# EUROPÄISCHE PATENTSCHRIFT

(11) **EP 4 188 629 B1**
(45) Veröffentlichungstag und Bekanntmachung des Hinweises auf die Patenterteilung: **05.11.2025**
(21) Anmeldenummer: 21755386.6
(22) Anmeldetag: 27.07.2021
(51) Int. Cl.: B23K 1/008, B23K 3/08, B23K 37/047, H01L 21/677, H01L 21/67

(54) **VORRICHTUNG ZUR VERLAGERUNG WENIGSTENS EINER BAUGRUPPE ZWISCHEN EINEM BEREITSTELLUNGSBEREICH UND EINEM ARBEITSBEREICH**
DEVICE FOR SHIFTING AT LEAST ONE SUB-ASSEMBLY BETWEEN A PROVISIONING ZONE AND A WORKING ZONE
DISPOSITIF POUR DÉPLACER AU MOINS UN SOUS-ENSEMBLE ENTRE UNE ZONE D'APPROVISIONNEMENT ET UNE ZONE DE TRAVAIL

(30) Priorität: 28.07.2020 DE 102020119877
(43) Veröffentlichungstag der Anmeldung: 07.06.2023
(73) Patentinhaber: Siegfried Hofmann GmbH, 96215 Lichtenfels (DE)
(72) Erfinder: FESEKER, Daniel, 96215 Lichtenfels (DE); DEUERLING, Michael, 96215 Lichtenfels (DE); FÖRSTE, Michael, 96215 Lichtenfels (DE); FUHRMANN, Kai, 96215 Lichtenfels (DE); GÜNTHER, Johannes, 96215 Lichtenfels (DE); BECHMANN, Benedikt, 96215 Lichtenfels (DE); NOLDEN, Heinz, 31162 Bad Salzdetfurth (DE)
(74) Vertreter: Hafner & Kohl PartmbB
(86) Internationale Anmeldenummer: PCT/EP2021/070989
(87) Internationale Veröffentlichungsnummer: WO 2022/023334

(56) Entgegenhaltungen:
- WO-A1-2020/249474
- WO-A1-97/07924
- DE-A1- 102016 222 114
- US-A1- 2015 136 836
- US-A1- 2016 143 156
- US-B1- 6 860 417

## Beschreibung

Die Erfindung betrifft eine Vorrichtung zur Verlagerung wenigstens einer Baugruppe zwischen einem Bereitstellungsbereich und einem Arbeitsbereich wenigstens einer Prozesskammer einer Prozesskammereinrichtung zum Reflow-Löten.

US6860417B1 offenbart einen Druckbehälterofen für einen temperierten Reflow-Löt-Prozess, wobei der Druckbehälter einen über ein elektrisches Heizelement zu beheizenden Ofen ausbildet, welcher aus einer zylindrischen Wand gebildet wird und an den Enden durch zwei Platten verschlossen ist. Kerngedanke der US6860417B1 ist es ein Werkstücktransportsystem anzugeben, welches ein Bewegen von Werkstücken durch einen Druckbehälter ohne nennenswerte Vibrationen oder Stöße ermöglicht.

Die Erfindung betrifft eine Vorrichtung nach Anspruch 1. Dabei umfasst die Baugruppe typischerweise eine mit Leiterbahnen versehene Platine und weiteren Elektronikbauteilen, welche auf der Platine an- bzw. aufgesetzt sind. Diese Baugruppe wird in die Prozesskammer der Prozesskammereinrichtung verbracht und dort mit thermischer Energie und/oder mit einer definierten Gasatmosphäre, z. B. einer Inertgasatmosphäre, beaufschlagt. In diesem Zuge bildet sich eine dauerhafte zumindest elektrische Verbindung zwischen den Bauteilen und der Platine bzw. zwischen den Elektronikbauteilen und den Leiterbahnen der Platine aus. Entsprechende Vorrichtungen, auch als Reflow-Öfen bezeichnet, sind aus dem Stand der Technik dem Grunde nach bekannt.

Der Erfindung liegt die Aufgabe zugrunde, eine Vorrichtung anzugeben, welche insbesondere im Hinblick auf eine einfache und schnelle sowie kostengünstige Maßnahme die Handhabung von wenigstens einer in und/oder aus einer Prozesskammer einzubringenden oder herauszubringenden Baugruppen ermöglicht. Insbesondere kann eine Zuführung und/oder eine Entnahme von einer in einer Prozesskammer mit thermischer Energie beaufschlagten Baugruppe vorteilhafter ausgestaltet bzw. ausgeführt werden.

Die Aufgabe wird durch eine Vorrichtung zur Verlagerung wenigstens einer Baugruppe zwischen einem Bereitstellungsbereich und einem Arbeitsbereich wenigstens einer Prozesskammer einer Prozesskammereinrichtung zum Löten gemäß Anspruch 1 gelöst. Die hierzu abhängigen Ansprüche betreffen mögliche Ausführungsformen der Vorrichtung.

Die Erfindung betrifft eine Vorrichtung zur Verlagerung wenigstens einer Baugruppe zwischen einem Bereitstellungsbereich, insbesondere einem einer Trageinrichtung zugeordneten Bereitstellungsbereich, und einem Arbeitsbereich wenigstens einer Prozesskammer einer Prozesskammereinrichtung zum Löten, insbesondere zum Reflow-Löten einer Baugruppe. In die Prozesskammer kann beispielsweise ein Reflow-Löt-Prozess ausgeführt werden, hierzu wird wenigstens eine Baugruppe, bestehend aus wenigstens zwei Bauteilen, eingebracht und durch Beaufschlagung mit thermischer Energie eine Verbindung einzelner Bestandteile der Baugruppe hergestellt, wobei eine flüssige Phase durch Schmelzen eines Lotes oder durch Diffusion an den Grenzflächen entstehen kann.

In der Regel werden die Bauteile nicht in deren Tiefe aufgeschmolzen. Es bildet sich hierbei typischerweise eine stoffschlüssige Verbindung der Bauteile durch das Aufschmelzen und Erstarren des Lotes. Die verwendete Vorrichtung ist eingerichtet, eine definierte Temperierung der Baugruppe bzw. der Bauteile und des Lotes zu erreichen, sodass dabei ein Aufschmelzen des Lotes erreicht wird.

Die Vorrichtung umfasst wenigstens ein Verlagerungsmittel, wobei die wenigstens eine Baugruppe vermittels einer von dem Verlagerungsmittel, insbesondere unmittelbar, übertragenen oder erzeugten und auf die Baugruppe einwirkenden Kraft, insbesondere Druckkraft, zumindest abschnittsweise eine Verlagerungsbewegung derart ausführt und/oder eine derartige Verlagerungsbewegung ausführbar ist, dass die wenigstens eine Baugruppe verlagert wird. Mit anderen Worten ist die Vorrichtung eingerichtet, dass ein Verlagerungsmittel zumindest temporär in unmittelbarem oder mittelbarem Kontakt mit der wenigstens einen Baugruppe steht und diese verschiebt bzw. verlagert. Die Verlagerung kann durch eine entsprechende Krafteinleitung auf die wenigstens eine Baugruppe erfolgen, sodass diese von einem ersten Ort zu einem weiteren Ort verlagert wird. Konkret wird die Baugruppe aufgrund der von dem Verlagerungsmittel ausgehenden Krafteinwirkung zwischen einem außerhalb der Prozesskammer liegenden Bereitstellungsbereich und einem in wenigstens einer Prozesskammer liegenden Arbeitsbereich verlagert. Der Arbeitsbereich kann hierbei ein Volumen im Inneren der Prozesskammer bzw. den Innenraum der Prozesskammer ausbilden, innerhalb dem die wenigstens eine Baugruppe während der thermischen Energiebeaufschlagung und damit während des Lötprozesses (z. B. während des Reflow-Lötens) verweilt bzw. dort angeordnet ist.

Das Verlagerungsmittel kann es beispielsweise ermöglichen, die wenigstens eine auf der Trageinrichtung und/oder in der Prozesskammer befindliche Baugruppe zu verschieben. Alternativ oder zusätzlich kann das Verlagerungsmittel eine erste Baugruppe mit einer Druckkraft beaufschlagen, wobei die erste Baugruppe eine weitere Baugruppe zumindest temporär berührt und über den Kontakt der ersten Baugruppe mit der weiteren Baugruppe die auf die erste Baugruppe einwirkende Druckkraft auf die weitere Baugruppe einwirkt und damit schließlich zumindest abschnittsweise beide Baugruppe eine gezielte Verlagerung aufgrund der Einwirkung des, insbesondere sich linear und/oder parallel zu einer Haupterstreckungsebene einer Baugruppe bewegenden, Verlagerungsmittels erfährt.

Die Krafteinwirkung, insbesondere eine Druckkraftbeaufschlagung oder Zugkraftbeaufschlagung, der wenigstens einen Baugruppe durch das Verlagerungsmittel kann zumindest eine aktive Bewegungskomponente in einem gesamten Bewegungsweg der wenigstens einen Baugruppe zwischen einem Bereitstellungsbereich und einem Arbeitsbereich ausbilden. Mit anderen Worten wird zumindest teilweise (bezogen auf die Gesamtstrecke) eine Umsetzbewegung der wenigstens einen Baugruppe zwischen einem trageinrichtungsseitigen Bereitstellungsbereich und einem prozesskammereinrichtungsseitigen Arbeitsbereich durch das Verlagerungsmittel initiiert.

Es ist vorgesehen, dass die Vorrichtung eine wenigstens ein Lagerungsmittel umfassende Trageinrichtung umfasst, wobei die wenigstens eine Baugruppe zumindest abschnittsweise, bevorzugt überwiegend, während der Verlagerungsbewegung auf dem wenigstens einen Lagerungsmittel, insbesondere unmittelbar, anordenbar oder angeordnet ist und vermittels dem Lagerungsmittel zumindest in Richtung der Verlagerungsbewegung beweglich und/oder bewegbar an der Trägereinrichtung gelagert ist. Beispielsweise kann das Lagerungsmittel eine Gleitoberfläche aufweisen, welche ein Verschieben einer auf dem Lagerungsmittel aufliegenden Baugruppe mit einem geringen Schiebewiderstand ermöglicht. Alternativ kann das Lagerungsmittel zumindest abschnittsweise als ein flächiger Bereich mit einer punkt- und/oder linienförmiger Kontaktfläche ausgebildet sein. Alternativ oder zusätzlich kann das Lagerungsmittel zumindest teilweise als ein beweglich, insbesondere drehbeweglich, an einer Trageinrichtung angeordnetes oder ausgebildetes Lagerungsmittel ausgebildet sein. Zum Beispiel umfasst das Lagerungsmittel ein Kugel- und/oder Wälzlager. Unabhängig von dem Funktionsprinzip des Lagerungsmittels kann dieses bevorzugt derart auf eine an der Trageinrichtung angeordnete bzw. auf eine durch die Trageinrichtung getragene Baugruppe einwirken, dass die wenigstens eine Baugruppe zumindest parallel zu der Verlagerungsbewegung bzw. in Richtung der Verlagerungsbewegung einen geringen oder einen reduzierten Schiebewiderstand und/oder Zugwiderstand aufweist. Beispielsweise kann das Lagerungsmittel als Wälzlager ausgebildet sein, dessen Innenring drehfest an der Trageinrichtung befestigt ist und dessen Außenring mit seiner äußeren Mantelfläche den Kontaktbereich für den Kontakt mit der wenigstens einen Baugruppe bildet.

Die Verlagerungsbewegung definiert sich als Bewegung der wenigstens einen Baugruppe von einem trageinrichtungsseitigen Bereitstellungsbereich zu wenigstens einem prozesskammereinrichtungsseitigen Arbeitsbereich und/oder umgekehrt. Auch kann die Verlagerungsbewegung eine Bewegung der wenigstens einen Baugruppe von einem prozesskammerseitigen Arbeitsbereich zu einem Sammelbereich einer Sammeleinrichtung und/oder umgekehrt umfassen.

In einer weiteren vorteilhaften Ausführungsform kann es vorgesehen sein, dass die Vorrichtung eingerichtet ist, in einem ersten Abschnitt bzw. in einer ersten Teilstecke der Verlagerungsbewegung eine Verlagerung der wenigstens einen Baugruppe zumindest durch eine Bewegung eines die wenigstens eine Baugruppe zumindest abschnittsweise tragenden Tragmittels, insbesondere eines Lagerungsmittels, der Trageinrichtung und in einem weiteren Abschnitt bzw. einer weiteren Teilstrecke der Verlagerungsbewegung eine Verlagerung der wenigstens einen Baugruppe zumindest durch die Einwirkung der durch das Verlagerungsmittel auf die wenigstens eine Baugruppe einwirkenden Kraft ausgeführt wird. Mit anderen Worten kann wenigstens eine Baugruppe, insbesondere eine Gruppe von Baugruppen, an einem ersten (Strecken-)Abschnitt der Verlagerungsbewegung durch ein Mitbewegen dieser Baugruppe(n) mit dem diese Baugruppe(n) tragenden Tragmittel, z. B. einem zumindest abschnittsweise linear bewegbaren Lagerungsmittel, erfolgen. In einem weiteren (Strecken-)Abschnitt der Verlagerungsbewegung wird bzw. werden die Baugruppe(n) durch die Kraftbeaufschlagung (z. B. Zug- oder Druckkrafteinwirkung) des Verlagerungsmittels in Bewegung versetzt.

Es ist vorgesehen, dass, insbesondere an einem Endbereich der Trageinrichtung, zumindest ein Rückhaltemittel anordenbar oder angeordnet ist, das zwischen einer Sperrposition und einer Freigabeposition bewegbar bzw. verfahrbar ist, wobei in der Sperrposition eine Bewegung von wenigstens einer von der Trageinrichtung getragenen Baugruppe in Richtung der Verlagerungsbewegung gehemmt bzw. gesperrt und in der Freigabeposition eine Bewegung von wenigstens einer von der Trageinrichtung getragenen Baugruppe in Richtung der Verlagerungsbewegung freigegeben wird. Mit anderen Worten kann die wenigstens eine Baugruppe durch unmittelbaren oder mittelbaren Kontakt mit dem zumindest einen in der Sperrposition befindlichen Rückhaltemittel zurückgehalten bzw. an einer Weiterverlagerung entlang bzw. gemäß der Verlagerungsbewegung gehemmt bzw. gestoppt werden.

Es ist möglich, dass das zumindest eine Rückhaltemittel in der Sperrposition zumindest phasenweise einer auf die Baugruppe wirkenden Bewegungskraft entgegenwirken. So kann es beispielsweise vorgesehen sein, dass die Baugruppe zumindest teilweise vermittels der Bewegung eines die Baugruppe tragenden Tragmittels bzw. Lagerungsmittels eine Verlagerungsbewegung ausführt bzw. in Verlagerungsbewegungsrichtung bewegt wird. Durch den Kontakt der Baugruppe mit dem Rückhaltemittel wird eine Gegenkraft auf die Verlagerungsbewegung erzeugt, welche dazu führt, dass die Baugruppe relativ zur Trageinrichtung und/oder relativ zu dem Rückhaltemittel ortsfest gehalten bzw. zurückgehalten wird und die Tragmittel, insbesondere die Lagerungsmittel, eine Relativbewegung zu der Baugruppe ausführen derart, dass die Tragmittel, insbesondere die Lagerungsmittel, relativ zu der wenigstens einen Baugruppe bewegt werden. Zum Beispiel "fahren" die Lagerungsmittel unterhalb von der von diesen Lagerungsmitteln getragenen Baugruppe vorbei. Es ist etwa vergleichbar mit einem auf einem Fließband geförderten Gegenstand, auf den eine entgegen der Förderbewegung des Fließbands entgegengerichtete Rückhaltekraft sich durch einen, insbesondere unmittelbaren, Kontakt des Gegenstands mit dem zumindest einem temporär ortsfesten Rückhaltemittel einstellt.

Das Zurückhalten bzw. Ortsfesthalten von wenigstens einer Baugruppe kann vorteilhaft sein, um in der Trageinrichtung befindliche Baugruppen kompakter anzuordnen. So kann ein in Verlagerungsrichtung gesehen vordere Baugruppe durch, insbesondere unmittelbaren, Kontakt mit dem Rückhaltemittel an einem Weitertransport gehindert werden. Die in Verlagerungsrichtung bzw. in Verlagerungsbewegung hinter der vorderen Baugruppe typischerweise zunächst beabstandet liegenden Baugruppen können deren Abstand auf die vordere Baugruppe aufgrund dessen zurückhalten vermittels dem Rückhaltemittel reduzieren, da diese weitergefördert werden können. Dies kann so lange erfolgen, bis die der vorderen Baugruppe benachbarte Baugruppe die vordere Baugruppe berührt und die Rückhaltewirkung mittelbar über die vordere Baugruppe auf die benachbarte Baugruppe einwirkt. Mit anderen Worten kann das zumindest eine Rückhaltemittel eingesetzte werden, um, insbesondere in Wechselwirkung mit einem förderbandartigen Transport der Baugruppen in der Trageinrichtung, eine kompaktere Anordnung der Baugruppen in oder an der Trageinrichtung zu erreichen. Eine derart kompakte Anordnung der Baugruppen kann vorteilhaft sein, um möglichst viele Baugruppen in den Arbeitsbereich zu verbringen. Die vordere Baugruppe kann vermittels dem Rückhaltemittel in einer statischen Warteposition verharren, bis weitere Baugruppen zu der vorderen Baugruppe aufgeschlossen haben.

Es kann sich hierbei beispielsweise als vorteilhaft erweisen, wenn das Rückhaltemittel einen Abstützbereich zum zumindest temporären Abstützen von zumindest einer während wenigstens eines Abschnitts der Verlagerungsbewegung bewegten Baugruppe umfasst. Der Abstützbereich kann hierbei derart ausgestaltet sein, dass dieser eine geringe Reibung zu einer auf diesem abgestützten Baugruppe aufweist. Alternativ oder zusätzlich kann der Abstützbereich eine ähnliche oder identische Reibwirkung für eine auf diesem abgestützte und in Verlagerungsrichtung bewegte Baugruppe wie das trageinrichtungsseitige Lagerungsmittel und/oder wie ein prozesskammerseitiges Abstützmittel. Bevorzugt kann das Rückhaltemittel derart angeordnet oder ausgebildet sein, dass das Rückhaltemittel zumindest in der Freigabeposition eine von der wenigstens einen Baugruppe zu passierende (Strecke einer) Unterbrechung eines Kontaktbereichs der Baugruppe mit der Trageinrichtung und der Prozesskammer reduziert bzw. verkürzt. Der Kontaktbereich kann wenigstens zwei Kontaktteilbereiche aufweisen, wobei ein erster Kontaktteilbereich durch den von der Baugruppe berührten Bereich der Trägereinrichtung (z. B. Tragmittel/Lagerungsmittel) und der zweite Kontaktteilbereich durch den von der Baugruppe berührten Bereich der Prozesskammer (z. B. Abstützmittel) gebildet wird.

Um ein temporäres Verschließen der wenigstens einen Prozesskammer durch ein Verschlussmittel zu ermöglichen, ist allgemeint ein Mindestabstand zwischen Trageinrichtung und Prozesskammer für die Anordnung des Verschlussmittels notwendig. Dieser Mindestabstand kann beispielsweise durch ein bewegbares Abstützelement das zumindest temporär eine Baugruppe trägt und hierbei temporär im Spaltbereich anordenbar bzw. einfahrbar ist, reduziert werden. In einer optionalen Ausführungsform kann die Funktion des verfahrbaren Abstützelements in ein Rückhaltemittel integriert sein.

Durch den rückhaltemittelseitigen oder abstützelementseitigen Abstützbereich kann der Kontaktbereich um einen weiteren Kontaktteilbereich temporär (z. B. wenn sich das Rückhaltemittel in der Freigabeposition befindet) ergänzt bzw. erweitert werden, sodass der berührungslose und/oder führungslose Weg der Baugruppe zwischen der Trageinrichtung und der Prozesskammer verkleinert wird. Dies birgt den Vorteil, dass die in der Vorrichtung zum Löten verarbeitbare Mindestbaulänge der wenigstens einen zu Lötenden Baugruppe verkleinert werden kann, da selbst im Spaltbereich hinreichende Führung und/oder Bewegung bei geringeren Längenmaßen der Baugruppe gewährleistet wird.

Die Vorrichtung kann beispielsweise eingerichtet sein, in zumindest einem Abschnitt der Verlagerungsbewegung die wenigstens eine Baugruppe vermittels einer überlagerten bzw. zusammenfallenden Einwirkung einer durch das Verlagerungsmittel auf die wenigstens eine Baugruppe einwirkenden Kraft (z. B. Druckkraft) und einer Bewegung des die wenigstens eine Baugruppe tragenden Tragmittels, insbesondere zumindest eines Lagerungsmittels, einer Trageinrichtung bewegt wird. Mit anderen Worten kann es vorgesehen sein, dass auf wenigstens einer auf der Trageinrichtung angeordneten Baugruppe überlagerte bzw. zusammenwirkende Ursachen für die Förderung der Baugruppe auf diese einwirken. Damit wird es ermöglicht den Betrag der auf die Baugruppe vermittels der von dem Verlagerungsmittel auf die Baugruppe, insbesondere unmittelbar durch Kontakt, einwirkende Kraft(-einwirkung) zu reduzieren, da die effektive Bewegung der wenigstens einen Baugruppe aus dem Einwirkung des Verlagerungsmittels und der Bewegung der Trag- bzw. Lagerungsmittel resultiert. Auch werden etwaige reibende Effekte und/oder Beschleunigungsgradienten an den Kontaktbereichen zwischen Trageinrichtung und der wenigstens einen Baugruppe reduziert.

Es ist möglich, dass die Vorrichtung wenigstens ein um eine, insbesondere senkrecht zur Verlagerungsbewegung ausgerichteten, Rotationsachse drehbar gelagertes Lagerungsmittels aufweist. Bevorzugt kann zumindest ein Bestandteil der Verlagerungsbewegung der wenigstens einen auf einem Lagerungsmittel angeordneten Baugruppe aufgrund der Einwirkung des Verlagerungsmittels auf die wenigstens eine Baugruppe unter, insbesondere gleichzeitiger, Drehbewegung des wenigstens einen drehbar gelagerten Lagerungsmittels um die Rotationsachse ausführbar sein bzw. ausgeführt werden. Während dieser Drehbewegung des Lagerungsmittels kann die Baugruppe auf dem Lagerungsmittel, insbesondere unmittelbar, aufliegen. Folglich wird eine das Lagerungsmittel in Drehbewegung versetzende Kraft ausgehend von dem Verlagerungsmittel über die Baugruppe auf das Lagerungsmittel übertragen. Alternativ oder zusätzlich kann das Lagerungsmittel eine passive Bewegung ausführen, d. h. eine zumindest abschnittsweise oder vollständig, insbesondere ausschließlich, durch das Verlagerungsmittel und die Baugruppe initiierte Bewegung ausführen. Das Lagerungsmittel kann vorzugsweise als eine Gruppe von mehreren Wälzlagern ausgebildet sein, welche zumindest in Richtung der Verlagerungsbewegung drehbar an der Trageinrichtung gelagert sind. Dabei können die, z. B. rollenartigen, Lagerungsmittel zumindest teilweise, insbesondere sämtliche Lagerungsmittel, drehbar an der Trageinrichtung gelagert sein. Hierbei können die Lagerungsmittel beispielsweise eine Drehbewegung auf mehreren parallel zueinander ausgerichteten und insbesondere senkrecht zur Verlagerungsbewegung ausgerichteten Rotationsachsen ausführen.

Die wenigstens zwei Lagerungsmittel bzw. wenigstens zwei Lagerungselemente eines Lagerungsmittels können beispielsweise über ein Verbindungsglied, z. B. ein Förderband oder eine Kette, verbunden sein und zumindest abschnittsweise in Richtung der Verlagerungsbewegung bewegbar, insbesondere motorisch antreibbar, ausgebildet oder angeordnet sein. Das Verbindungsglied kann beispielsweise beweglich an der Trageinrichtung gelagert sein, sodass durch eine gezielte Bewegung, insbesondere durch ein gezieltes motorisches Antreiben, des Verbindungsglieds eine entsprechende Bewegung der an dem Verbindungsglied angeordneten Lagerungsmittels ausgeführt werden kann bzw. ausführbar ist.

Bevorzugt können wenigstens zwei Lagerungsmittel eine zumindest abschnittsweise lineare Transportbewegung in Richtung der Verlagerungsbewegung ausführen, in welcher eine auf diesen Lagerungsmitteln angeordnete Baugruppe zumindest einen Bestandteil einer, insbesondere linearen, Verlagerungsbewegung ausführt. Das Verbindungglied ist über eine Lagerung relativ zur Trageinrichtung beweglich gelagert. Die Lagerung kann z. B. eine einen geschlossenen Kreis bzw. einen geschlossenen Ring folgende kreis- bzw. ringförmige Bewegung des Verbindungsglieds und der an dem Verbindungsglied befestigten Lagerungsmittel ermöglichen. Mit anderen Worten kann das Verbindungsglied eine Endlosbewegung nach Art beispielsweise eines Förderbands ausführen und damit eine über die Tragmittel, insbesondere die Lagerungsmittel, auf dem Verbindungsglied aufliegende Baugruppe eine zumindest abschnittsweise geradlinige Bewegung ausführen. Es ist möglich, dass die Lagerungsmittel in einem Kreislauf geführt sind bzw. bewegt werden, wobei an einem geradlinigen Bewegungsabschnitt der Lagerungsmittel innerhalb des Bewegungskreislaufs ein Anteil, bevorzugt ein überwiegender Anteil, der Verlagerungsbewegung einer Baugruppe im Bereich der Trageinrichtung ausgeführt bzw. initiiert wird.

Das wenigstens eine Verlagerungsmittel kann beispielsweise zumindest ein an einem verlagerungsmittelseitigen Haltekörper bewegbar gelagertes Verlagerungselement zum zumindest temporären Kontakt mit wenigstens einer Baugruppe umfassen, wobei das Verlagerungselement zumindest abschnittsweise parallel und/oder senkrecht zur Verlagerungsbewegung bzw. parallel und/oder senkrecht zur Trageinrichtung bewegbar ist. Eine parallel und/oder senkrecht zur Verlagerungsbewegung ausgeführte Bewegung kann hierbei beispielsweise eine Bewegung in Richtung der Verlagerungsbewegung oder seitlich zur Verlagerungsbewegung oder senkrecht nach oben oder unten zur Verlagerungsbewegung umfassen.

Das Verlagerungselement ist in einer optionalen Ausführungsform ausschließlich parallel und/oder senkrecht zur Verlagerungsbewegung bewegbar an einem Haltekörper gelagert, wobei der Haltekörper die, insbesondere ausschließliche, Verbindung des Verlagerungselements mit einem Basiskörper der Trageinrichtung und/oder einem Grundkörper des Verlagerungsmittels ausbildet. Damit kann ein kostengünstiger und/oder eine präzise Bewegung gewährleistender Aufbau der Vorrichtung erreicht werden. Bevorzugt ist der verlagerungsmittelseitige Grundkörper die Verbindungsschnittstelle des Verlagerungsmittels mit der Trageinrichtung, wobei der Grundkörper mit dem trageinrichtungsseitigen Basiskörper verbindbar oder verbunden ist.

Das Verlagerungselement ist kann den Bestandteil des Verlagerungsmittels ausbilden, welcher, insbesondere ausschließlich, in einen unmittelbaren Kontakt mit der Baugruppe tritt, wobei der unmittelbare Kontakt auf die Baugruppe diese mit einer Druckkraft und/oder Zugkraft beaufschlagt.

Das Verlagerungsmittel ist beispielsweise derart bewegbar an der Trageinrichtung angeordnet, dass das Verlagerungsmittel zumindest eine auf der Trageinrichtung angeordnete Baugruppe, bevorzugt wenigstens zwei auf der Trageinrichtung angeordnete Baugruppen, besonders bevorzugt wenigstens drei auf der Trageinrichtung angeordnete Baugruppen, überfahren bzw. mit seiner Bewegung überbrücken kann. Damit kann das Verlagerungsmittel, insbesondere das Verlagerungselement derart relativ zu wenigstens einer auf der Trageinrichtung platzierten Baugruppen bewegbar sein oder bewegt werden, dass das Verlagerungsmittel ohne Bewegung der Baugruppe oder unabhängig von einer Bewegung der Baugruppen an einen beliebigen Endbereichen der Baugruppen in Richtung Verlagerungsbewegung verfahren werden kann. Hierzu kann das Verlagerungsmittel in einer ersten Position auf Höhe der wenigstens einen Baugruppe angeordnet sein und ausgehend von dieser Position in eine höhergelegene oder tiefergelegene Position durch eine, insbesondere ausschließlich, senkrecht zur Haupterstreckungsebene der auf der Trageinrichtung angeordneten wenigstens einen Baugruppe ausgerichtete Bewegung bewegt werden. In dieser aus der Haupterstreckungsebene der wenigstens einen Baugruppe abgehobenen oder tieferliegenden Position heraus, kann das Verlagerungsmittel die Baugruppe über- bzw. unterfahren.

Nachdem das Verlagerungsmittel die Baugruppe in einer Richtung, insbesondere im Wesentlichen parallel zur bestimmungsgemäßen Verlagerungsbewegung, der Baugruppe überbrückt oder unterfahren hat, kann das Verlagerungsmittel wieder in die in der Haupterstreckungsebene der Baugruppe liegende Ebene abgesenkt bzw. hochgefahren werden. Vorzugsweise kann diese Bewegung innerhalb des Haupterstreckungsfläche (in der Draufsicht aus betrachtet) des Trageinrichtung erfolgen.

Der, insbesondere als Halterahmen ausgebildete, Haltekörper kann beispielsweise bewegbar an einem Grundkörper des Verlagerungsmittels und/oder an der Trageinrichtung befestigbar oder befestigt sein. Beispielsweise ist der Haltekörper an dem Grundkörper und der Grundkörper an der Trageinrichtung befestigt, so kann z. B. der Haltekörper ausschließlich über den Grundkörper mit der Trageinrichtung bzw. mit der die wenigstens eine Baugruppe tragenden Bestandteile der Trageinrichtung befestigt sein. Bevorzugt ist der Haltekörper, insbesondere ausschließlich, senkrecht und/oder parallel bewegbar zu einer Haupterstreckungsebene des Haltekörpers und/oder zu einer Haupterstreckungsebene des Grundkörpers und/oder zu einer Haupterstreckungsebene der Trageinrichtung. Der Haltekörper kann beispielsweise als Halterahmen ausgebildet sein, wobei das wenigstens eine Verlagerungselement nach Art eines Kreuzschlittens in seiner Position verfahrbar ist.

Der Haltekörper kann z. B. zwischen einer ersten, mit dem Grundkörper und/oder mit der Trageinrichtung zumindest überwiegend, insbesondere vollständig, in Deckung stehenden Deckungsposition und einer zweiten, seitlich versetzt zu dem Grundkörper und/oder zu der Trageinrichtung positionierten Auszugsposition, bevorzugt motorisch angetrieben, verfahrbar sein oder verfahren werden. In der Auszugsposition des Haltekörpers wird es ermöglicht, dass das am Haltekörper beweglich gelagerte Verlagerungselement über die Deckfläche des Grundkörpers (in der Draufsicht) hinaus sich in neben dem Grundkörper liegende Bereiche zumindest temporär erstreckt. Die Deckungsposition umfasst hierbei z. B. eine in der Draufsicht sich ergebende Deckfläche von mindestens 70 %, bevorzugt mindestens 85 %, besonders bevorzugt von mindestens 95 %, höchst bevorzugt von mindestens 99 %, der Gesamtfläche des Haltekörpers mit dem Grundkörper und/oder mit der Trageinrichtung jeweils aus der Draufsicht aus betrachtet.

Der Grundkörper kann ein separates, insbesondere rahmenartiges, Bauteil oder eine Gruppe von Bauteilen darstellen, welches auf der Trageinrichtung montiert ist. Alternativ kann der Grundkörper zumindest abschnittsweise, insbesondere vollständig, als Bestandteil der Trageinrichtung ausgebildet sein.

Die Trageinrichtung kann beispielsweise parallel zu der Verlagerungsbewegung verlaufende und insbesondere parallel zueinander ausgerichtete Wandkörper umfassen, wobei zwischen zwei Wandkörpern eine Aufnahmespur zur Aufnahme wenigstens einer Baugruppe, insbesondere zur Aufnahme einer ersten Gruppe an Baugruppen, ausgebildet wird. Mit anderen Worten kann der zwischen zwei benachbarten Wandkörpern liegende Bereich eine Aufnahmespur ausbilden. Bevorzugt entspricht der Abstand der Wandkörper zumindest annähernd dem in Querrichtung zur Verlagerungsbewegung vorliegendem Längenmaß der wenigstens einen Baugruppe. Die Wandkörper tragen z. B. über Lagerungs- und/oder Tragmittel, insbesondere unmittelbar, die wenigstens eine Baugruppe innerhalb der Aufnahmespur. Die Wandkörper bilden einen Bestandteil der Trageinrichtung, sodass an oder in den Wandkörpern die Lagerungsmittel angeordnet oder ausgebildet sein können.

Es ist möglich, dass die Trageinrichtung wenigstens eine Aufnahmespur zur tragenden Aufnahme wenigstens einer Baugruppe aufweist, wobei die wenigstens eine Aufnahmespurbreite veränderbar, insbesondere durch einen Motor veränderbar, ist. Eine Aufnahmespur meint hierbei, dass es einen geradlinigen Aufnahmekanal gibt, in welchen wenigstens eine Baugruppe, bevorzugt mindestens zwei Baugruppen, aufgenommen werden kann bzw. können. Durch eine Verstellbarkeit der Aufnahmespurbreite, z. B. durch eine Parallelverschiebung wenigstens einer von zumindest zwei Wandkörpern kann die Aufnahmespur an die Breite bzw. an ein quer zur Verlagerungsbewegung sich erstreckendes Längenmaß der wenigstens einen Baugruppe angepasst werden.

Die Trageinrichtung kann beispielsweise rechtwinklig zur Verlagerungsbewegung, insbesondere zugleich parallel zu einer Haupterstreckungsebene der Trageinrichtung, der wenigstens einen Baugruppe zur Ausführung einer Ausrichtbewegung verfahrbar sein oder verfahren werden, um ein Aufnehmen und/oder Abgeben einer Baugruppe von einem Einbringbereich zu einer vordefinierten Aufnahmespur zu ermöglichen. Bevorzugt ist vermittels der Ausrichtbewegung wahlweise eine erste Aufnahmespur der Trageinrichtung zur Aufnahme von wenigstens einer Baugruppe und wenigstens eine zweite Aufnahmespur der Trageinrichtung zur Aufnahme von wenigstens einer weiteren Baugruppe relativ zu einem, insbesondere einspurigen, Einbringbereich zur Einbringung über zur Abgabe von Baugruppen an die Trageinrichtung in eine zum Einbringbereich korrespondierende Ausrichtung und/oder Position verfahrbar. Damit kann es beispielsweise ermöglicht werden, trotz eines ortfesten, und vorzugsweise einspurigen, Einbringbereichs durch gezielte Verlagerung der Trageinrichtung in einer ersten Relativposition von Trageinrichtung und Einbringbereich dem Einbringbereich eine erste Aufnahmespur der Trageinrichtung und in einer zweiten Relativposition von Trageinrichtung und Einbringbereich dem Einbringbereich eine zweite Aufnahmespur der Trageinrichtung derart zuzuordnen bzw. derart in eine korrespondierende Übergabeposition zu verfahren, dass eine Baugruppe von dem Einbringbereich in oder an eine gezielte bzw. gewünschte Aufnahmespur der Trageinrichtung übergeben bzw. eingebracht werden kann. Mit anderen Worten meint eine korrespondierende Ausrichtung und/oder Position, dass in einem ersten Zustand eine erste Spur der Trageinrichtung mit dem, insbesondere einspurigen, Einbringbereich(s) in Deckung bzw. in eine Übergabeposition bringbar ist oder gebracht wird und in einem weiteren Zustand eine weitere, von der ersten Spur unterschiedliche Spur der Trageinrichtung mit dem Einbringbereich(s), in Deckung bzw. in eine Übergabeposition bringbar ist bzw. gebracht wird.

Eine Prozesskammereinrichtung kann beispielsweise wenigstens zwei übereinander angeordneten Prozesskammern umfassen, wobei die Trageinrichtung derart höhenverlagerbar bzw. derart in seiner Höhe verfahrbar ist, dass wenigstens eine, insbesondere sämtliche, von der Trageinrichtung getragene Baugruppe(n) wahlweise in eine erste oder eine weitere Prozesskammer der Prozesskammereinrichtung verlagerbar bzw. bewegbar ist. Mit anderen Worten trägt eine Trageinrichtung wenigstens eine Baugruppe, wobei diese wenigstens eine Baugruppe in einer ersten Übergabeposition der Trageinrichtung in eine erste Prozesskammer bewegbar bzw. verlagerbar und in einer zweiten Übergabeposition der Trageinrichtung in eine weitere Prozesskammer bewegbar bzw. verlagerbar ist. Hierzu wird die Trageinrichtung zumindest in deren Höhenposition relativ zu den Prozesskammern verfahren und in eine mit der jeweiligen Prozesskammer zugeordnete Übergabeposition verbracht.

Es ist möglich, dass eine Prozesskammereinrichtung wenigstens eine Prozesskammer aufweist, wobei die wenigstens eine Prozesskammer eine erste und eine weitere Übergabeöffnung zum Hindurchführen wenigstens einer Baugruppe zwischen einem prozesskammerseitigen Arbeitsbereich und einem trageinrichtungsseitigen Bereitstellungsbereich und/oder einem sammeleinrichtungsseitigen Sammelbereich umfasst, wobei die Übergabeöffnungen an zwei gegenüberliegenden Seitenflächen der, insbesondere quaderartigen, Prozesskammer angeordnet oder ausgebildet sind. Beispielsweise weist die Prozesskammer eine von der Draufsicht aus betrachtete rechteckige, insbesondere quadratische, Grundflächenform auf, wobei eine erste Übergabeöffnung an einer ersten Seitenfläche und eine weitere Übergabeöffnung an einer der ersten Seitenfläche gegenüberliegenden Seitenfläche angeordnet oder ausgebildet ist.

Eine Vorrichtung kann beispielsweise eine Prozesskammereinrichtung mit wenigstens einer Prozesskammer sowie eine Sammeleinrichtung umfassen, wobei die Sammeleinrichtung einen Sammelträger umfasst, welcher horizontal und/oder vertikal verfahrbar ist, um wenigstens eine aus der Prozesskammer herausbewegte Baugruppe aufzunehmen, bevorzugt weist die Sammeleinrichtung mehrere, insbesondere übereinander und/oder nebeneinander angeordnete oder ausgebildete, Gruppen von Aufnahmespuren auf. Die Sammeleinrichtung kann beispielsweise als Puffer für aus den Prozesskammern herausgeführte Baugruppen dienen. Insbesondere kann in der Sammeleinrichtung ein gezieltes thermisches Abkühlen der Baugruppen erfolgen. Alternativ oder zusätzlich kann die Sammeleinrichtung dazu genutzt werden, um eine gezielte Ausgabe der wenigstens einen Baugruppe aus der Vorrichtung, insbesondere aus der Prozesskammer, an eine mit der Vorrichtung bzw. mit der Prozesskammer im Materialstrom bzw. in dem Verarbeitungsweg verbundenen Abführeinrichtung zu ermöglichen. Beispielsweise kann die Reihenfolge der Aufnahme von aus einer Prozesskammer herausbewegten und in der Sammeleinrichtung aufgenommenen Baugruppe und der Reihenfolge der Abgabe von aus der Sammeleinrichtung abgegebenen und von der Abführeinrichtung aufgenommenen Baugruppe abweichen oder identisch sein. D. h. es kann vermittels der Sammeleinrichtung zumindest temporär ein FIFO-Prinzip (Firstin-First-Out-Prinzip) angewandt werden und/oder zumindest temporär ein von einem FIFO-Prinzip abweichender Modus "gefahren" werden. So ist es beispielsweise möglich, die Reihenfolge der aus der Sammeleinrichtung an eine Abführeinrichtung abgegebenen Baugruppen (a) von der Reihenfolge der in die Sammeleinrichtung eingebracht Baugruppen und/oder (b) von der Reihenfolge der in die Prozesskammer von der Trageinrichtung eingebrachten Baugruppen und/oder (c) von der Reihenfolge der von einem Einbringbereich an die Trageinrichtung eingebrachten Baugruppen abweichen zu lassen.

Die Sammeleinrichtung kann beispielsweise zwei gegenüberliegende Durchführöffnungen aufweisen, wobei eine erste, zur Prozesskammer zugewandte Durchführöffnung zur Aufnahme der Baugruppe in die Sammeleinrichtung und eine zweite von der Prozesskammer abgewandte Durchführöffnung zur Abgabe der Baugruppe an die Abführeinrichtung dient. Beispielsweise kann die Sammeleinrichtung nach Art eines horizontal und vertikal bewegbaren regalartigen Systems ausgebildet sein, wobei an beiden Haupterstreckungsbegrenzungsebenen der Sammeleinrichtung Durchführöffnungen zur Aufnahme bzw. zur Abgabe der in der Sammeleinrichtung aufgenommenen Baugruppen vorgesehen sein können.

Es ist möglich, dass die Vorrichtung ein Verlagerungsmittel umfasst, das eingerichtet ist, (a) eine in einem trageinrichtungsseitigen Bereitstellungsbereich angeordnete Baugruppe in einen prozesskammerseitigen Arbeitsbereich und/oder (b) eine in einem prozesskammerseitigen Arbeitsbereich angeordnete Baugruppe in einen trageinrichtungsseitigen Bereitstellungsbereich und/oder (c) eine in einem prozesskammerseitigen Arbeitsbereich angeordnete Baugruppe in einen sammeleinrichtungsseitigen Sammelbereich und/oder (d) eine in einem sammeleinrichtungsseitigen Sammelbereich angeordnete oder ausgebildete Baugruppe in einen prozesskammerseitigen Arbeitsbereich zu bewegen. Insbesondere kann diese Bewegung durch Kontakt und Aufbringen einer Kraft, bevorzugt einer Druckkraft und/oder Zugkraft, auf wenigstens eine Baugruppe durch ein verlagerungsmittelseitiges Verlagerungselement erfolgen. Die Bewegung der Baugruppe während der Überführung zwischen dem Bereitstellungsbereich und dem Arbeitsbereich und/oder zwischen dem Arbeitsbereich und dem Sammelbereich kann, bevorzugt wenigstens überwiegend, besonders bevorzugt ausschließlich, durch Einwirkung des trageinrichtungsseitigen Verlagerungsmittels erfolgen. So ist es möglich, dass die wenigstens eine den Arbeitsbereich umfassende Prozesskammereinrichtung, insbesondere deren Prozesskammer, und/oder die den Sammelbereich umfassende Sammeleinrichtung keine eine überwiegende Verlagerung oder keinerlei Verlagerung der Baugruppe antreibenden bzw. aktiv initiierenden Elemente umfasst. Mit anderen Worten kann die wenigstens eine Prozesskammer und/oder die wenigstens eine Sammeleinrichtung ohne eine aktiv antreibende Verlagerungsfunktion für die wenigstens eine Baugruppe ausgebildet sein und die Verlagerungsfunktion ausschließlich durch Mittel (z. B. Verlagerungsmittel und/oder bewegte Trag- und/oder Lagermittel) der Trägereinrichtung erfolgen.

Das Verlagerungsmittel kann beispielsweise derart eingerichtet sein, dass eine Bewegung einer Baugruppe (a) an einem und/oder über einen Spalt zwischen dem trageinrichtungsseitigen Bereitstellungsbereich und dem prozesskammerseitigen Arbeitsbereich und/oder (b) an einem und/oder über einen Spalt zwischen dem prozesskammerseitigen Arbeitsbereich und dem sammeleinrichtungsseitigen Sammelbereich und/oder (c) innerhalb des Arbeitsbereichs und/oder (d) innerhalb des Bereitstellungsbereichs, zumindest abschnittsweise, insbesondere vollständig, bevorzugt ausschließlich, durch die Einwirkung des Verlagerungsmittels erfolgt. Dadurch kann ein einfacher Aufbau erreicht werden, wobei die Verlagerungsinitiierungsfunktion lediglich an der Trageinrichtung vorgehalten wird. Auch wird damit ermöglicht, die den thermischen Schwankungen aufgrund des Prozesskammerbetriebs ausgesetzte Prozesskammereinrichtung einfach aufzubauen bzw. zumindest keine oder weniger für eine Baugruppeverlagerung eingesetzte Elemente diesen thermischen Schwankungen auszusetzen.

Es ist möglich, dass (a) das Verlagerungsmittel zumindest teilweise zu der Trageinrichtung und/oder (b) das Verlagerungselement zu dem Haltekörper und/oder (c) der Haltekörper zu dem Grundkörper und/oder zu der Trageinrichtung und/oder (d) das wenigstens eine Lagerungsmittel innerhalb der Trageinrichtung und/oder (e) das Lagerungsmittel um eine lagerungsmittelseitige Rotationsachse und/oder (f) eine Sammeleinrichtung, insbesondere ausschließlich, vermittels eines Motors verfahrbar bzw. bewegbar ist. Es kann beispielsweise vorgesehen sein, für jede der oben genannten Relativbewegungen der Bauteile der Vorrichtung jeweils einen eigenen Motor vorzusehen. Alternativ kann die Bewegung von wenigstens zwei Bauteilen der Vorrichtung, ausgehend von einem gemeinsamen Motor über ein Übertragungsmittel zu verteilen.

Es ist möglich, dass eine Sammeleinrichtung eingerichtet ist, wenigstens eine aus der Prozesskammer herausbewegte Baugruppe aufzunehmen. Die Sammeleinrichtung kann beispielsweise eine Temperiereinrichtung, insbesondere eine Kühleinrichtung, umfassen. Alternativ kann der Sammeleinrichtung eine Temperier, insbesondere Kühleinrichtung, zugeordnet sein. Vermittels der Temperiereinrichtung, insbesondere Kühleinrichtung, kann wenigstens eine in der Sammeleinrichtung aufgenommene Baugruppe temperiert, insbesondere gekühlt, werden. So kann die beispielsweise eine Kühleinrichtung einen gekühlten Gasstrom in den Innenraum der Sammeleinrichtung einbringen, sodass damit die in diesem Innenraum der Sammeleinrichtung angeordneten Baugruppen gekühlt werden. Alternativ oder zusätzlich kann die Kühleinrichtung eine Kühlung von mit den Baugruppen in Kontakt stehenden Elementen ausführen, sodass aufgrund des Kontakts dieser Elemente mit der Baugruppe eine entsprechende Abkühlung der Baugruppen erfolgt. Es ist möglich, dass der Auszugskörper zumindest abschnittsweise relativ zu einer Trageinrichtung, insbesondere ausschließlich linear, beweglich gelagert oder ausgebildet ist, bevorzugt ist der Auszugskörper teleskopierbar ausgebildet.

Neben der Vorrichtung zur Verlagerung wenigstens einer Baugruppe betrifft die Offenbarung auch ein Verfahren zur Verlagerung wenigstens einer Baugruppe zwischen einem Bereitstellungsbereich und einem Arbeitsbereich wenigstens einer Prozesskammer einer Prozesskammereinrichtung zum Löten, insbesondere zum Reflow-Löten, wobei die Baugruppe vermittels einer von einem Verlagerungsmittel, insbesondere unmittelbar, übertragenen oder erzeugten, auf die Baugruppe einwirkenden Kraft, insbesondere Druckkraft, zumindest abschnittsweise eine Verlagerungsbewegung ausführt und verlagert wird. In einer bevorzugten Ausführungsform des Verfahrens wird eine Verlagerungsbewegung der wenigstens einen Baugruppe durch die unmittelbare Beaufschlagung dieser Baugruppe vermittels einer verlagerungsmittelseitig aufgebrachten Druckkraft ausgeführt. Mit anderen Worten kann die Baugruppe von dem Verlagerungsmittel geschoben oder gezogen werden, wobei die Trageinrichtung vorzugsweise Lagerungsmittel aufweist, welche während der verlagerungsmittelseitigen Druck- oder Zugkraftbeaufschlagung einen Schiebewiderstand der wenigstens einen Baugruppe gegenüber der Trägereinrichtung reduziert.

Sämtliche Vorteile, Einzelheiten, Ausführungen und/oder Merkmale der erfindungsgemäßen Vorrichtung sind auf das offenbarte Verfahren übertragbar bzw. anzuwenden.

Die Erfindung ist anhand von Ausführungsbeispielen in den Zeichnungen näher erläutert.

Dabei zeigt:
Fig. 1 eine Prinzipdarstellung einer Vorrichtung gemäß einem Ausführungsbeispiel;
Fig. 2 bis 7 Prinzipdarstellungen unterschiedlicher Zeitpunkte während der Verlagerung einer Baugruppe durch das Verlagerungsmittel gemäß einem Ausführungsbeispiel;
Fig. 8, 9 eine schematische Darstellung der Trageinrichtung in unterschiedlichen Positionen zur Aufnahme von Baugruppen aus einer Einbringeinrichtung in der Draufsicht gemäß einem Ausführungsbeispiel;
Fig. 10 eine perspektivische Prinzipdarstellung einer Vorrichtung gemäß einem Ausführungsbeispiel;

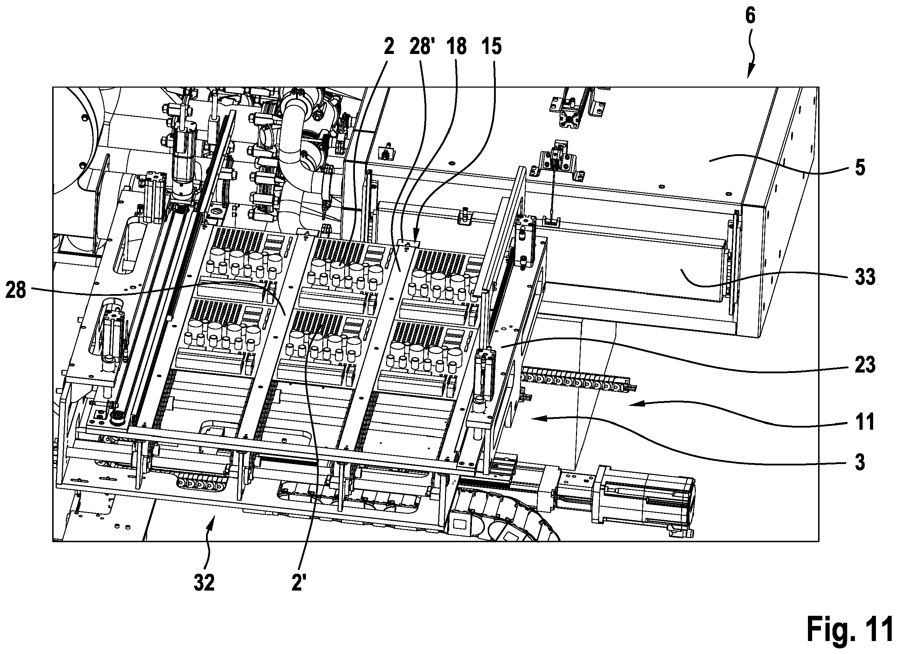

Fig. 11 eine perspektivische Prinzipdarstellung einer Baugruppen tragenden Trageinrichtung gemäß Figur 10;
Fig. 12 eine perspektivische Prinzipdarstellung der Trageinrichtung ohne Baugruppen gemäß Figur 10;

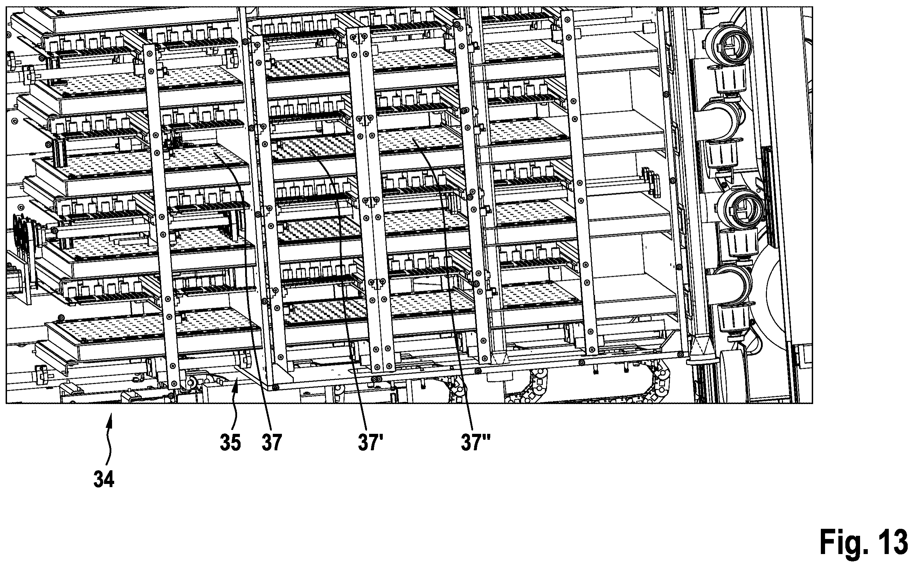

Fig. 13 eine perspektivische Prinzipdarstellung auf eine Sammeleinrichtung gemäß Figur 10.

In den Figuren ist eine Vorrichtung 1 zur Verlagerung wenigstens einer Baugruppe 2, 2' zwischen einem Bereitstellungsbereich 3 und einem Arbeitsbereich 4 wenigstens einer Prozesskammer 5 einer Prozesskammereinrichtung 6 zum Löten, insbesondere zum Reflow-Löten, der Baugruppen 2, 2' gezeigt. Hierbei wird an der Baugruppe 2, 2' bestehend aus wenigstens zwei Baugruppenteilelementen (nicht dargestellt) durch Einwirkung von thermischer Energie im Inneren der Prozesskammer 5 ein Lötverfahren ausgeführt, welches zu einer stoffschlüssigen Verbindung der Baugruppenelemente führt. An dem Bereitstellungsbereich 3 wird die wenigstens eine Baugruppe 2, 2' durch eine Trageinrichtung 11 gehalten und/oder getragen. Insbesondere kann die wenigstens eine Baugruppe 2, 2' schwerkraftbedingt auf der Trageinrichtung 11 aufliegen.

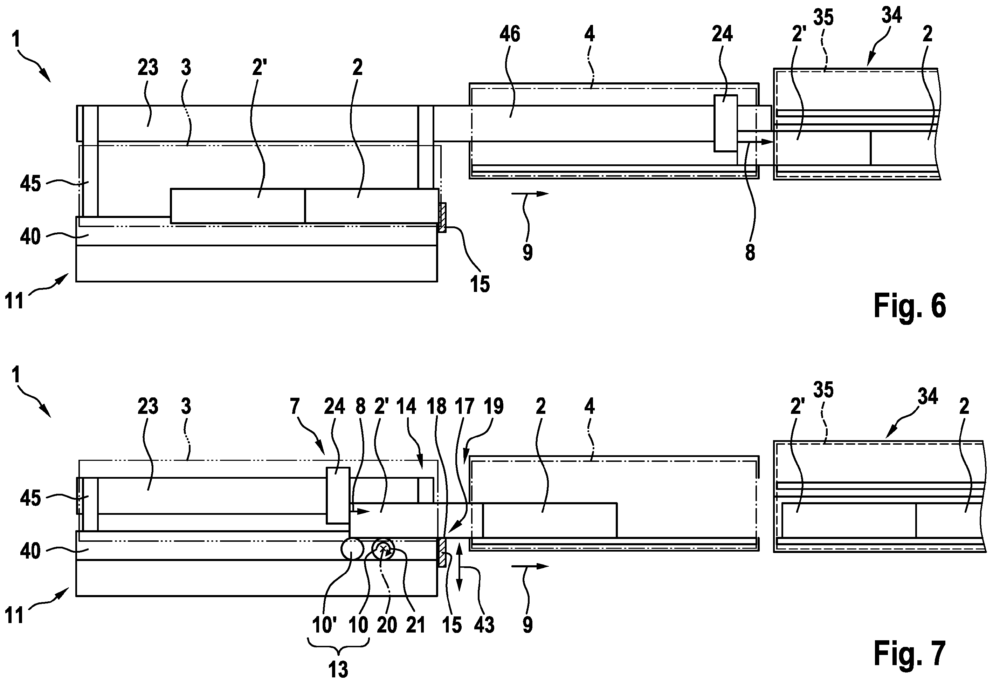

Die Vorrichtung 1 weist wenigstens ein Verlagerungsmittel 7 auf, das in seiner Position und/oder Ausrichtung bewegbar bzw. verändert ist. Die wenigstens eine Baugruppe 2, 2' wird vermittels einer von dem Verlagerungsmittel 7, insbesondere unmittelbar, übertragenen und/oder erzeugten, auf die Baugruppe 2, 2' einwirkenden Kraft 8 (vgl. Pfeil), insbesondere Druckkraft, zumindest abschnittsweise in eine Verlagerungsbewegung 9 versetzt, vgl. Figur 7. Mit anderen Worten führt die wenigstens eine Baugruppe 2, 2' durch die Kraftbeaufschlagung durch das Verlagerungsmittel 7 zumindest abschnittsweise eine Verlagerungsbewegung 9 aus, sodass die Baugruppe 2, 2' beispielsweise von einem trageinrichtungsseitigen Bereitstellungsbereich 3 zu einem prozesskammereinrichtungsseitigen Arbeitsbereich 4 und/oder umgekehrt verlagert werden kann. Durch den Kontakt des Verlagerungsmittels 7 kann wenigstens eine Baugruppe 2, 2' zur Ausführung der Verlagerungsbewegung 9 (an-)geschoben werden. Mit dem Schieben der Baugruppen 2, 2' durch das Verlagerungsmittel 7 erfolgt ein Umsetzen der wenigstens einen Baugruppe 2, 2', beispielsweise kann das Verlagerungsmittel 7 unmittelbar auf eine erste Baugruppe 2' und die erste Baugruppe 2' unmittelbar mit einer weiteren Baugruppe 2 in Kontakt stehen, sodass beide Baugruppen 2, 2' zur Ausführung der Verlagerungsbewegung 9 zumindest abschnittsweise gleichzeitig bewegt werden. Mit anderen Worten kann zumindest abschnittsweise die weitere Baugruppe 2 über die Einwirkung des Verlagerungsmittels 9 auf die erste Baugruppe 2' und die Einwirkung der ersten Baugruppe 2' auf die weitere Baugruppe 2 bewegt, insbesondere geschoben, werden.

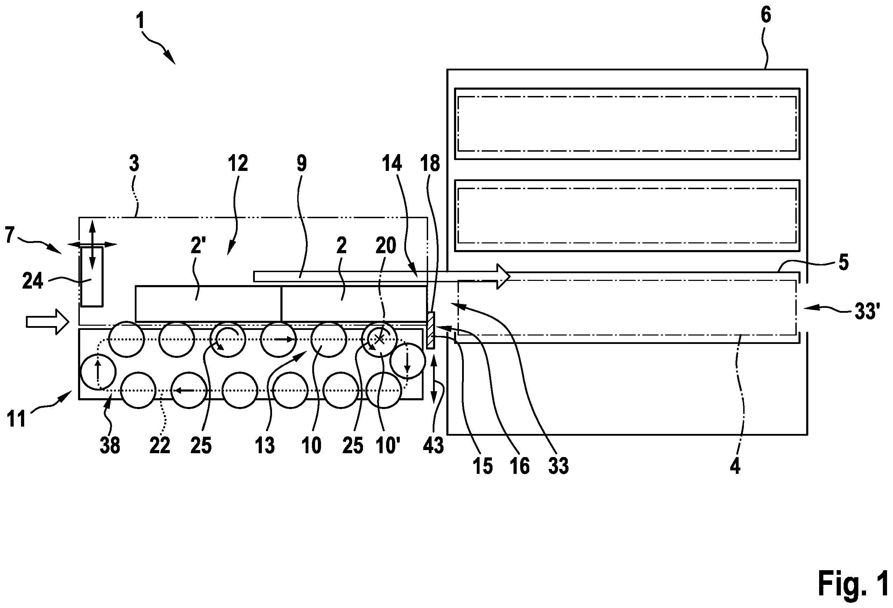

Die Trageinrichtung 11 kann wenigstens ein Lagerungsmittel 10, 10' umfassenden, vgl. Figur 1. Bevorzugt umfasst die Trageinrichtung 11 wenigstens zwei Lagerungsmittel 10, 10'. Die wenigstens eine Baugruppe 2, 2' ist zumindest abschnittsweise, bevorzugt überwiegend, während der Verlagerungsbewegung 9 auf dem wenigstens einen Lagerungsmittel 10, 10', insbesondere unmittelbar, anordenbar oder angeordnet. Z. B. liegen die Baugruppen 2, 2' während der Verlagerungsbewegung 9 während eines überwiegenden Streckenabschnitts auf den Lagerungsmitteln 10 auf. Vermittels dem wenigstens einen Lagerungsmittel 10, 10' kann die wenigstens eine Baugruppe 2, 2' zumindest in Richtung der Verlagerungsbewegung 9 beweglich und/oder bewegbar an der Trageinrichtung 11 gelagert sein. Mit anderen Worten ist kann ein Lagerungsmittel 10, 10` derart ausgebildet sein, dass eine an oder auf dem Lagerungsmittel 10, 10' angeordnete bzw. aufliegende Baugruppe 2, 2' bei einer Druckbeaufschlagung in Richtung der Verlagerungsbewegung 9 einen reduzierten Widerstand (Schiebewiderstand) aufweist. Beispielsweise kann das Lagerungsmittel 10, 10' zumindest abschnittsweise, insbesondere vollständig, als Gleitfläche ausgebildet sein, auf welcher die wenigstens eine Baugruppe 2, 2' während der Verlagerungsbewegung 9 der Baugruppe 2, 2' bewegbar ist. In einer optionalen und bevorzugten Ausführungsform ist das wenigstens eine Lagerungsmittel 10, 10' als Wälzlager (z. B. Rollen- und/oder Kugellager) bzw. als ein einen Wälzkörper ausgebildetes Lagerungsmittel 10, 10' ausgebildet.

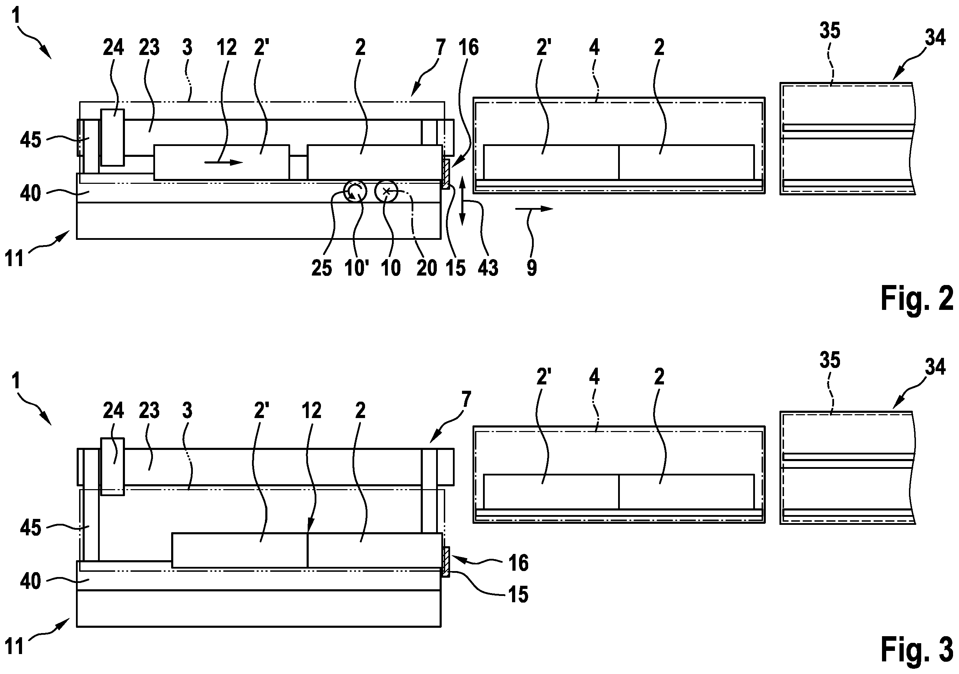

Es ist möglich, dass die Vorrichtung 1 eingerichtet ist, in einem ersten Abschnitt 12 (vgl. Figur 2, 3) der Verlagerungsbewegung 9 eine Verlagerung der wenigstens einen Baugruppe 2, 2' zumindest durch eine Bewegung eines die wenigstens eine Baugruppe 2, 2' zumindest abschnittsweise tragenden Tragmittels 13, insbesondere eines Lagerungsmittels 10, der Trageinrichtung 11 und in einem weiteren Abschnitt 14 (vgl. Figur 7) der Verlagerungsbewegung 9 eine Verlagerung der wenigstens einen Baugruppe 2, 2' zumindest durch die Einwirkung der vermittels dem Verlagerungsmittel 7 auf die wenigstens eine Baugruppe 2, 2' einwirkenden Kraft 8, insbesondere einer Druckkraft, ausgeführt wird. In der Ausführungsform gemäß Figur 1 ist ein erster Abschnitt 12 der Verlagerungsbewegung 9 gezeigt, bei welchem das Verlagerungsmittel 7 beabstandet von den Baugruppen 2, 2' platziert ist. Folglich wird in diesem Zustand keine Kraft 8, insbesondere keine Druckkraft, von dem Verlagerungsmittel 7 auf die wenigstens eine Baugruppe 2 aufgebracht. Die Verlagerungsbewegung 9 erfolgt in diesem Abschnitt 12, insbesondere ausschließlich, aufgrund einer Bewegung der hier beispielhaft als Lagerungsmittel 10, 10' ausgebildeten Tragmittel 13 der Trageeinrichtung 11. Die Lagerungsmittel 10, 10' sind beispielsweise mit einem Verbindungsglied 22 verbunden und derart an der Trageinrichtung 11 gelagert, dass die Lagerungsmittel 10, 10' mit dem Verbindungsglied 22 eine gemeinsame Relativbewegung zu der Trageinrichtung 11 bzw. zu einem Basiskörper 40 der Trageinrichtung 11 ausführen. Dadurch, dass die wenigstens eine Baugruppe 2, 2' auf dem wenigstens einen Lagerungsmittel 10, 10' aufliegt, wird die wenigstens eine Baugruppe 2, 2' durch die Relativbewegung der Tragmittel 13 gegenüber dem Basiskörper 40 der Trageinrichtung 11 gezielt verlagert bzw. dadurch ein Abschnitt 12 der Verlagerungsbewegung 9 der Baugruppe 2, 2' ausgeführt.

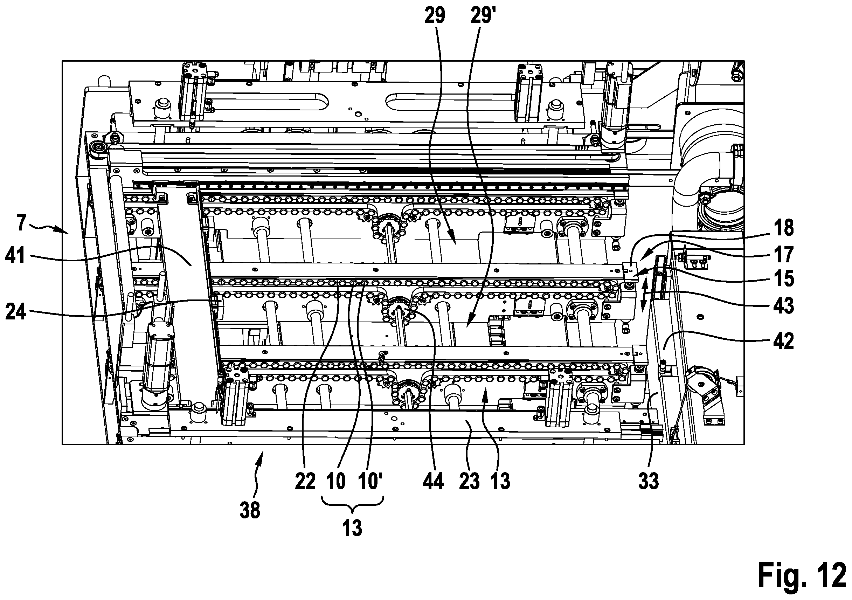

In und/oder an und/oder nahe bzw. unmittelbar angrenzend zu der Trageinrichtung 11 kann wenigstens ein Rückhaltemittel 15 angeordnet oder ausgebildet sein. Bevorzugt ist das wenigstens eine Rückhaltemittel 15 an einem Endbereich, insbesondere an dem der Prozesskammereinrichtung 6 zugewandte Ende, der Trageinrichtung 11 angeordnet. Das zumindest eine Rückhaltemittel 15 kann dabei als ein temporärer Baugruppenstopp bzw. als ein temporärer Boardstopp verwendet werden, wobei das zumindest eine Rückhaltemittel 15 zwischen einer Sperrposition 16 (s. Fig. 1, 12) und einer Freigabeposition 17 (s. Fig. 7) bewegbar ist. In der Sperrposition 16 wird eine Bewegung von wenigstens einer von der Trageinrichtung 11 getragenen Baugruppe 2 in Richtung der Verlagerungsbewegung 9 gehemmt bzw. blockiert. In der Freigabeposition 17 kann eine Bewegung von wenigstens einer von der Trageinrichtung 11 getragenen Baugruppe 2 in Richtung der Verlagerungsbewegung 9 freigegeben werden.

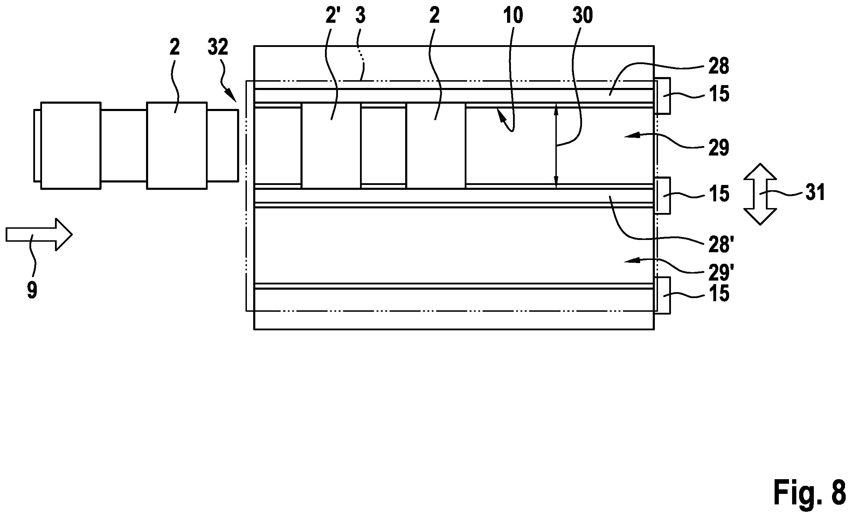

Beispielsweise ist aus Figur 8 die Position der Rückhaltemittel 15 ersichtlich, diese sind beispielsweise derart ausgebildet, dass diese in die Breite der Aufnahmepuren 29, 29' zur Aufnahme der Baugruppen 2, 2' einragen und temporär durch Kontakt mit den Baugruppen 2, 2' diese von einer weiteren Bewegung zurückhalten. Die Rückhaltemittel 15 können einen, insbesondere plattenartigen, Kontaktkörper umfassen, welcher in seiner Höhe verfahrbar ist, z. B. vermittels eines Stellzylinders, vgl. Figur 12. Die Oberfläche des, insbesondere plattenartigen, Kontaktkörpers kann zumindest abschnittsweise als Abstützbereich 18 zur zumindest temporären Abstützung der Baugruppen 2, 2' eingesetzt werden.

So ist es möglich, dass das wenigstens eine Rückhaltemittel 15 in der Sperrposition 16 eingerichtet ist, wenigstens eine auf der Trageinrichtung 11 in Verlagerungsrichtung 9 bewegte Baugruppe 2 an einem Weitertransport, insbesondere an einen Transport in einen Arbeitsbereich 4 der Prozesskammereinrichtung 6 zu hindern. Hierzu kann das Rückhaltemittel 15 beispielsweise als vertikal beweglicher Kontaktkörper (vgl. Pfeil 43) ausgebildet sein, der bei Einnehmen einer Positionierung auf Höhe der Baugruppen 2, 2' deren Weiterbewegen hemmt bzw. als Anschlag für diese Baugruppe 2, 2' wirkt. So ist es möglich, dass trotz fortlaufender Bewegung der Lagerungsmittel 10, 10' entlang der Ringbahn 38 bzw. der Relativbewegung der Lagerungsmittel 10, 10' und des Verbindungsglieds 22 relativ zu dem Basiskörper 40 der Trageinrichtung 11, die wenigstens eine Baugruppen 2, 2' ortsfest relativ zu der Position, insbesondere des Basiskörpers 40, der Trageinrichtung 11 verharrt und sich eine Abrollbewegung bzw. eine Drehbewegung 25 der Lagerungsmittel 10, 10' aufgrund der Relativbewegung in Reaktion auf das Zurückhalten der wenigstens einen Baugruppen 2, 2' durch das Rückhaltemittel 15 ergibt.

Das Rückhaltemittel 15 kann alternativ oder zusätzlich einen Abstützbereich 18 umfassen, der geeignet ist, zumindest temporären ein Abstützen von zumindest einer während wenigstens eines Abschnitts der Verlagerungsbewegung 9 bewegten Baugruppe 2 zu ermöglichen. Ein Abstützen meint hierbei, dass zumindest ein Teil der Gewichtskraft der wenigstens einen Baugruppe 2 sich zumindest teilweise auf dem Abstützbereich 18 abstützt. Mit anderen Worten kann der Abstützbereich 18 beispielsweise als Verlängerung des Tragmittels 13, insbesondere der Lagerungsmittel 10, 10', der Trageinrichtung 11 angesehen werden. Bevorzugt ist das Rückhaltemittel 15 derart angeordnet oder ausgebildet, dass das Rückhaltemittel 15 zumindest oder ausschließlich in der Freigabeposition 17 durch dessen Abstützbereich 18 eine von der wenigstens einen Baugruppe 2, 2' zu passierende Strecke (a) einer Unterbrechung eines Kontaktbereichs der Baugruppe 2, 2' mit der Trageinrichtung 11 und der Prozesskammer 5 bzw. (b) eines Spalts 19 zwischen der Trageinrichtung 11 und der Prozesskammer 5 reduziert bzw. verkürzt.

Es ist möglich, dass die Vorrichtung 1 eingerichtet ist, in zumindest einem Abschnitt der Verlagerungsbewegung 9 die wenigstens eine Baugruppe 2 vermittels einer überlagerten Einwirkung einer durch das Verlagerungsmittel 7 auf die wenigstens eine Baugruppe 2 einwirkenden Kraft 8 und einer Bewegung des die wenigstens eine Baugruppe 2 tragenden Tragmittels 13, insbesondere zumindest eines Lagerungsmittels 10, 10', der Trageinrichtung 11 zu bewegen. Hierbei kann sich beispielsweise im Fall von drehbar gelagerten Lagerungsmitteln 10, 10` ergeben, dass sich die Lagerungsmittel 10, 10' in einer geringeren Geschwindigkeit (Drehgeschwindigkeit) um deren jeweilige Rotationsachse 20 drehen als im Fall der nicht-Bewegung der Lagerungsmittel 10, 10' und des Verbindungsglieds 22 bzgl. deren gemeinsamen Relativbewegung relativ zu der Trageinrichtung 11, insbesondere zu dem Basiskörper 40 der Trageinrichtung 11. Mit anderen Worten kann das Verlagerungsmittel 7 die auf dem Lagerungsmitteln 10, 10' aufliegenden Baugruppen 2, 2' anschieben, wobei durch die bereits erfolgende Bewegung der Lagerungsmittel 10, 10' entlang der verbindungsgliedbedingten Relativbewegung bzw. Ringbewegung die effektive Bewegungskomponente ausgehend von dem Verlagerungsmittel 7 reduziert wird, womit der Betrag der von dem Verlagerungsmittel 7 auf die Baugruppe eingebrachte Kraft 8 reduzierbar und/oder steuerbar ist. So kann es z. B. vorgesehen sein, dass während des Inkontaktbringens des Verlagerungsmittels 7 mit einer Baugruppe 2, 2' und/oder während des Inkontaktbringens zweier Baugruppen 2, 2' zueinander aufgrund der Einwirkung des Verlagerungsmittels 7 auf eine der beiden Baugruppen 2, 2' durch eine Anpassung und/oder Ausführung einer Ringbewegung bzw. einer Relativbewegung der Tragmittel 13, insbesondere der Lagerungsmittel 10, 10', der Kraftbetrag reduziert einwirken kann im Vergleich zu dem Betrag der Kraft 8 während der Verlagerungsbewegung 9 nach dem Inkontaktbringen.

Das wenigstens eine Lagerungsmittel 10, 10', kann um eine, insbesondere senkrecht zur Verlagerungsbewegung 9 ausgerichteten, Rotationsachse 20 drehbar gelagert sein. Diese Rotationsachse 20 kann beispielsweise parallel zu der Haupterstreckungsebene der Trageinrichtung 11 und/oder zu der Haupterstreckungsebene zu der wenigstens einen auf der Trageinrichtung 11 getragenen Baugruppe 2, 2' ausgerichtet sein. Bevorzugt kann zumindest ein Bestandteil der Verlagerungsbewegung 9 der wenigstens einen auf einem Lagerungsmittel 10, 10' angeordneten Baugruppe 2, 2' aufgrund der Einwirkung des Verlagerungsmittels 7 auf die wenigstens eine Baugruppe 2, 2' zu einer Drehbewegung 21 bzw. zu einer Abrollbewegung um die Rotationsachse 20 des wenigstens einen drehbar gelagerten Lagerungsmittels 10 führen, vgl. Figur 7. Die Einwirkung des Verlagerungsmittels 7 kann hierbei eine Druckbeaufschlagung der Baugruppe 2, 2' in Richtung der Verlagerungsbewegung 9 umfassen.

Es ist ferner ersichtlich, dass die Drehbewegung 21 während der Einwirkung der durch das Verlagerungsmittels 7 auf die wenigstens eine Baugruppe 2 einwirkende Kraft 8, in eine abweichende Drehrichtung erfolgt als die Drehbewegung 25 der Lagerungsmittel 10, 10' die sich während des Zurückhaltens der wenigstens einen Baugruppe 2, 2' durch das sich in der Rückhalteposition befindliche Rückhaltemittel 15 ergibt, vgl. Figuren 1 und 7.

Wenigstens zwei Lagerungsmittel 10, 10' können über ein Verbindungsglied 22, z. B. über ein als Förderband oder als eine Kette ausgebildetes Verbindungsglied 22, verbunden und zumindest abschnittsweise in Richtung der Verlagerungsbewegung 9 bewegbar, insbesondere motorisch antreibbar, sein. Bevorzugt führen wenigstens zwei Lagerungsmittel 10, 10' eine zumindest abschnittsweise lineare Transportbewegung in Richtung der Verlagerungsbewegung 9 aus, in welcher eine auf diesen Lagerungsmitteln 10, 10' angeordnete Baugruppe 2, 2' zumindest einen Bestandteil einer, insbesondere linearen, Verlagerungsbewegung 9 ausführt. Das Verbindungsglied 22 ist über eine Lagerung beweglich an der Trageinrichtung 11 gelagert. Die Lagerung ermöglicht eine, insbesondere einem geschlossenen Ring folgende ringartige oder ringförmige Bewegung des Verbindungsglieds 22 und damit auch der an dem Verbindungsglied 22 befestigten Lagerungsmittels 10, 10'. Beispielsweise ist aus Figur 12 ein förderbandartiges Verbindungsglied 22 sichtbar, an welchem eine Vielzahl an jeweils drehbeweglich gelagerten Lagerungsmittel 10, 10' angeordnet sind. Über das Antriebsrad 44 kann ein Antreiben des Verbindungsglieds 22 und der Lagerungsmittel 10, 10' erfolgen. Über, beispielsweise als Kettenräder ausgebildete, Umlenkmittel wird das Verbindungsglied 22 an den Endbereichen der Trägereinrichtung 11 umgelenkt.

Das wenigstens eine Verlagerungsmittel 7 kann beispielsweise zumindest ein an einem verlagerungsmittelseitigen Haltekörper 23 bewegbar gelagertes Verlagerungselement 24 zum zumindest temporären Kontakt mit wenigstens einer Baugruppe 2 umfassen, wobei das Verlagerungselement 24 zumindest abschnittsweise parallel und/oder senkrecht zur Verlagerungsbewegung 9 bewegbar ist. Hierbei kann das Verlagerungsmittel 24 relativ zu dem Haltekörper 23 bewegbar gelagert bzw. verfahrbar sein. Der Haltekörper 23 ist ein Bestandteil des Verlagerungsmittels 7 und kann z. B. als Halterahmen ausgebildet sein.

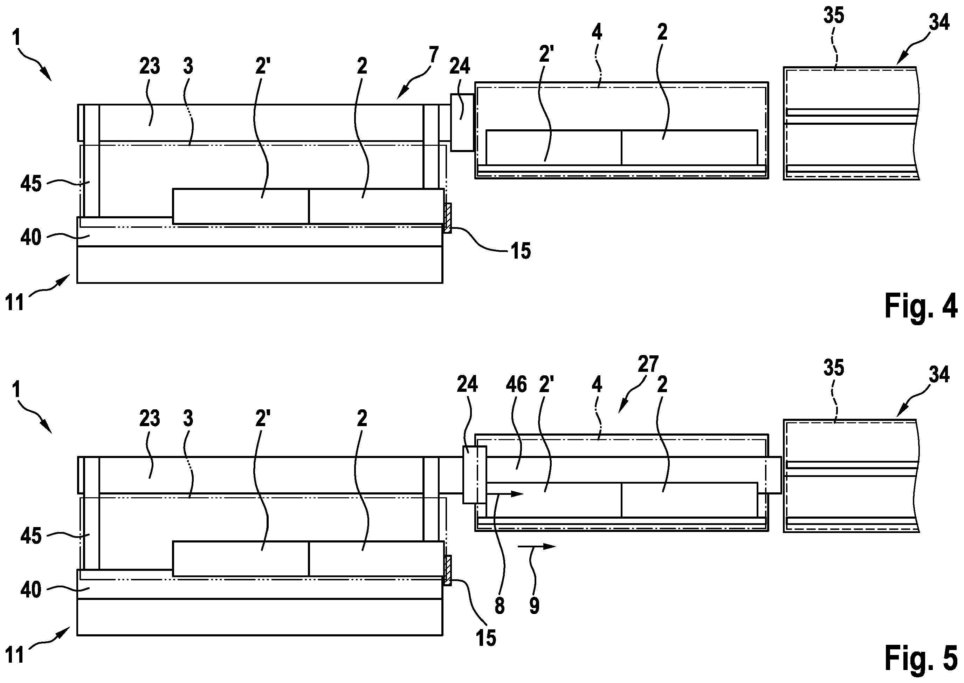

Wie beispielhaft in der Ausführungsform der Figur 5 ersichtlich, weist das Verlagerungsmittel 7 einen Grundkörper auf, welcher die Schnittstelle des Verlagerungsmittels 7 zur übrigen Trageinrichtung 11 bildet. Zum Beispiel ist der Grundkörper mit dem Basiskörper 40 der Trageinrichtung 11, insbesondere flächig, verbunden. Ferner weist das Verlagerungsmittel 7 Säulenkörper 45 auf, welche den Haltekörper 23 gegenüber dem Grundkörper und/oder gegenüber dem Basiskörper 40 bewegbar bzw. verfahrbar abstützen. Der Haltekörper 23 weist einen Auszugkörper 46 auf, der ein an diesem beweglich gelagertes Verlagerungselement 24 und/oder eine an diesem beweglich gelagerte Traverse 41 in eine seitlich zum Grundkörper und/oder Basiskörper 40 gelegene Position gelangen lässt.

Durch ein, insbesondere lineares, Verfahren bzw. durch ein, insbesondere lineares, Bewegen der Traverse 41 kann das wenigstens eine Verlagerungsmittel 7 eine, insbesondere lineare, Verlagerungsbewegung 9 auf die wenigstens eine Baugruppe 2, 2' ausführen. Bevorzugt weist das Verlagerungsmittel 7 eine Vielzahl an Verlagerungselementen 24 auf, welche kraft- und/oder formschlüssig, insbesondere zerstörungsfrei lösbar, mit der Traverse 41 verbunden sind. Damit kann auf einfache und komfortable Weise ein Austausch der im direkten Kontakt mit den Baugruppen 2 stehenden Verbindungselemente 24 ausgeführt werden. Beispielsweise sind an der Traverse 41 - wie in der in Figur 12 gezeigten Ausführungsform ersichtlich - wenigstens zwei, insbesondere drei, Verlagerungselemente 24 angeordnet. Alternativ oder zusätzlich kann jeder Aufnahmespur 29, 29' der Trageinrichtung 11 jeweils wenigstens ein Verlagerungselement 24, bevorzugt genau ein Verlagerungselement 24, zugeordnet sein. Auch kann es beispielsweise vorgesehen sein, dass in unterschiedlichen Aufnahmespuren 29, 29', diesen jeweils zugeordnete Verlagerungselemente 24 unabhängig voneinander verfahren werden können bzw. verfahrbar sind. Damit kann es beispielsweise ermöglicht werden, dass in unterschiedlichen Aufnahmespuren 29, 29' der Trageinrichtung 11 angeordnete Baugruppen 2, 2' unabhängig voneinander durch eine gezielte Bewegung der entsprechenden Verlagerungselemente 24 bewegt werden können.

Die Traverse 41 kann wenigstens eine Aufnahmespur 29, 29', bevorzugt sämtliche Aufnahmespuren 29, 29', der Trageinrichtung 11 überspannen bzw. übergreifen. Insbesondere kann die Traverse 41 an den seitlichen Endbereichen der Trageinrichtung 11 platziert sein und/oder an einem Haltekörper 23 und/oder an einem Auszugskörper 46 der Trageinrichtung 11 beweglich gelagert sein.

Wie in den Figuren 2 bis 7 schematisch dargestellt, kann ausgehend von dem Verlagerungsmittel 7 eine gezielte Bewegung wenigstens einer Baugruppe 2 im Bereitstellungsbereich 3 sowie im Arbeitsbereich 4 erfolgen. Das Verlagerungselement 24 des Verlagerungsmittels 7 kann beispielsweise derart bewegbar an der Trageinrichtung 11 angeordnet oder ausgebildet sein, dass das Verlagerungselement 24 bzw. wenigstens ein Bestandteil des Verlagerungsmittels 7 zumindest eine auf der Trageinrichtung 11 angeordnete Baugruppe 2, bevorzugt wenigstens zwei auf der Trageinrichtung 11 angeordnete Baugruppen 2, 2' überfahren kann. Hierzu kann das Verlagerungselement 24 bzw. zumindest ein Bestandteil des Verlagerungsmittels 7 in einer ersten Position (vgl. Figur 2) auf Höhe der wenigstens einen an der Trageinrichtung 11 angeordneten Baugruppe 2, 2' platziert sein und ausgehend von dieser Position in eine relativ höhergelegene oder tiefergelegene Position, z. B. durch eine senkrecht zur Haupterstreckungsebene ausgerichtete Bewegungskomponente, relativ zu der auf der Trageinrichtung 11 angeordneten wenigstens einen Baugruppe 2 bewegt werden. Dies kann dadurch erreicht werden, dass das Verlagerungselement 24 gegenüber einer ortsfesten Baugruppe 2, 2' senkrecht nach oben oder unten bewegt wird (nicht dargestellt) oder dadurch, dass das die Baugruppe 2, 2' tragende Mittel (z. B. Trageinrichtung 11) zumindest teilweise relativ zu einem zumindest in dessen Höhe ortsfesten Verlagerungselement 24 senkrecht nach oben oder unten verlagert wird. Schließlich können beispielsweise sowohl das Verlagerungsmittel 24 als auch das die Baugruppe 2, 2' tragende Mittel der Trageinrichtung 11 jeweils eine Bewegung ausführen, die zu einem aus einer gemeinsamen Ebene verfahren des Verlagerungsmittels 24 und der Baugruppe 2, 2' führt.

In dieser aus der Haupterstreckungsebene der wenigstens einen Baugruppe 2 herausgefahrenen Position des Verlagerungselements 24, kann dieses bzw. zumindest ein Bestandteil des Verlagerungsmittels 7 die Baugruppe 2 über- bzw. unterfahren. Nachdem das Verlagerungselement 24 die Baugruppe 2 in einer Richtung parallel zur bestimmungsgemäßen Verlagerungsbewegung 9 der Baugruppe 2 überbrückt/überfahren (bzw. unterfahren) hat, vgl. Figur 4, ist das Verlagerungselement 24 an einem dem der Prozesskammern 5 zugewandten Endabschnitt des Bereitstellungsbereichs 3 angeordnet. Ausgehend von dieser Position des Verlagerungselements 24 kann der Haltekörper 23 und/oder ein an dem Haltekörper 23 bewegbar gelagerter Auszugskörper 46 zumindest abschnittsweise in eine in den Arbeitsbereich 4 zumindest einragende Auszugsposition 27 ausgefahren werden, vgl. Figur 5. Bevorzugt kann es vorgesehen sein, dass der Haltekörper 23 und/oder ein an dem Haltekörper 23 bewegbar gelagerter Auszugskörper 46 in das Innere der Prozesskammer 5 zumindest überwiegend, besonders bevorzugt vollständig, einragt. Mit anderen Worten kann der Haltekörper 23 bzw. ein an diesem gelagerter Auszugskörper 46 beispielsweise zwischen einer ersten, mit dem Basiskörper 40 und/oder mit der Trageinrichtung 11 zumindest überwiegend, insbesondere vollständig, in Deckung (Draufsicht) stehenden Deckungsposition (vgl. Figur 4) und einer zweiten, seitlich versetzt zu dem Basiskörper 40 und/oder zu der Trageinrichtung 11 positionierten Auszugsposition 27 (s. Figur 5), bevorzugt motorisch angetrieben, verfahrbar bzw. ausziehbar sein. Durch das temporäre Einragen des Haltekörpers 23 und/oder des an dem Haltekörper 23 ausfahrbar gelagerten Auszugskörpers 46 in den Arbeitsbereich 4 der Prozesskammereinrichtung 6 wird der potenzielle Bewegungsbereich des Verlagerungselements 24 bzw. wenigstens eines Bestandteils des Verlagerungsmittels 7 in den Arbeitsbereich 4 temporär erweitert. In Figur 7 ist ein Herausschieben der in der Prozesskammer 5 platzierten Baugruppen 2, 2' gezeigt, wobei diese Baugruppen 2, 2' über eine an dem der Trageinrichtung 11 abgewandten Ende der Prozesskammer 5 angeordneten oder ausgebildeten Übergabeöffnung 33' zu einem Sammelbereich 35 verschoben werden. Damit erfolgt eine Entleerung der Prozesskammer 5.

Abweichend von einem gänzlichen Überfahren einer Gruppe von Baugruppen 2 kann das Verlagerungselement 24 auch selektiv einzelne Baugruppen 2 überfahren und somit diese einzeln in den Arbeitsbereich 4 hineinverschieben. Alternativ oder zusätzlich kann die Verlagerungseinrichtung 24 einzelne Baugruppen 2 einer innerhalb des Arbeitsbereichs 4 angeordneten Gruppe von Baugruppen 2 durch entsprechende Bewegung der Verlagerungseinrichtung 24 aus dem Arbeitsbereich 4 der Prozesskammereinrichtung 6 herausbewegen. Hierbei kann die Verlagerungseinrichtung 24 sich gezielt neben eine zu bewegende, insbesondere isolierte, Baugruppe 2 bewegen und diese hinein- bzw. hinausbewegen.

Es ist möglich, dass der Haltekörper 23 oder ein am Haltekörper 23 beweglich gelagerter Auszugskörper 46 aktiv oder passiv ausziehbar oder ausschiebbar ausgebildet ist. Mit anderen Worten kann der Haltekörper 23 oder ein Auszugskörper 46 derart ausgebildet sein, dass zumindest Teile dieser, insbesondere horizontal, bewegbar ausgebildet sind oder sich bewegen lassen. So kann beispielsweise der Haltekörper 23 selbst oder ein am Haltekörper 23 beweglich gelagerter Auszugskörper 46 eingerichtet sein, eine, insbesondere ausschließlich lineare, Bewegung auszuführen. Beispielsweise ist der Haltekörper 23 und/oder der Auszugskörper 46 zumindest, bevorzugt überwiegend, besonders bevorzugt vollständig, abschnittsweise teleskopierbar ausgebildet.

Die Bewegung der wenigstens einen Baugruppe 2, 2' in einem Übergangsbereich zwischen der Prozesskammer 5 und dem Sammelbereich 35 und/oder im Sammelbereich 35 bzw. innerhalb des Sammelträgers 36 kann beispielsweise zumindest teilweise durch die Einwirkung des Verlagerungsmittels 7, insbesondere durch Kontakt mit dem Verlagerungselement 24, erfolgen. Es ist möglich, dass die Bewegung der wenigstens einen Baugruppe 2 im Übergangsbereich zwischen der Prozesskammer 5 und dem Sammelbereich 35 und/oder innerhalb des Sammelbereichs 35 bzw. innerhalb des Sammelträgers 36 zumindest abschnittsweise, insbesondere ausschließlich über ein der Sammeleinrichtung 34 zugeordnetes Bewegungsmittel (nicht dargestellt) ausführbar ist bzw. wird.

Dadurch, dass der Haltekörper 23 und/oder der am Haltekörper 23 ausfahrbar gelagerte Auszugkörper 46 nur temporär in den Arbeitsbereich 4 der Prozesskammer 5 einragt bzw. aus diesem auch wieder herausbewegt werden kann, wird es ermöglicht, dass die Prozesskammer 5 bzw. die Übergabeöffnungen 33, 33' der wenigstens einen Prozesskammer 5, 5' durch ein Verschlussmittel 42 verschließbar ist. Mit anderen Worten kann ein an der Trageinrichtung 11 angeordnetes Verlagerungsmittel 7 aus der Prozesskammer 5 herausbewegt werden und damit ein Hindernis für ein Verschließen der Übergabeöffnung 33 entfernt werden.

Nach der Entleerung des Prozesskammer 5 kann wenigstens ein Bestandteil des Verlagerungsmittels 7 bzw. das wenigstens eine Verlagerungselement 24 in eine in Bewegungsrichtung 9 betrachtete, vor und in der Ebene der wenigstens einen auf der Trageinrichtung 11 angeordneten Baugruppe 2, 2' liegende Position positioniert werden. Hierzu kann der die Baugruppe 2, 2' im Bereitstellungsbereich 3 tragende Bestandteil der Trageinrichtung 11 von der tieferliegenden Position wieder nach oben verfahren werden, sodass die Baugruppe 2, 2' wieder auf Höhe (in einem gemeinsamen/überschneidenden Ebenenbereich) mit dem Verlagerungselement 24 liegt, vgl. Position in Figur 2. Ausgehend von dieser Position kann wenigstens ein Bestandteil des Verlagerungsmittels 7 bzw. kann das wenigstens eine Verlagerungselement 24 als Schieber bzw. als Mittel zur Einbringung einer Druckkraft auf diese Baugruppe 2, 2' dienen und schließlich eine Verschiebung bzw. ein Einschieben der Baugruppe 2, 2' in die Prozesskammer 5 ausführen, vgl. Figur 7.

Der, insbesondere als Halterahmen ausgebildete, Haltekörper 23 kann beispielsweise bewegbar an einem Grundkörper des Verlagerungsmittels 7 und/oder an einem Basiskörper 40 der Trageinrichtung 11 befestigbar oder befestigt sein. Bevorzugt ist der Haltekörper 23 zumindest abschnittsweise senkrecht und/oder parallel (a) zu einer Haupterstreckungsebene des Haltekörpers 23 und/oder (b) zu einer Haupterstreckungsebene des Grundkörpers und/oder des Basiskörpers 40 und/oder (c) zu einer Haupterstreckungsebene der Trageinrichtung 11 bewegbar. Eine senkrechte Bewegbarkeit des Haltekörpers 23 kann z. B. durch teleskopierbare Säulenkörper 45, welche den Haltekörper 23 zu einem Grundkörper und/oder zu einem Basiskörper 40 abstützen erzielt werden. Alternativ kann der Haltekörper 23 an starren bzw. nicht teleskopierbaren Säulenkörpers 45 bewegbar befestigt sein, derart, dass eine Höhenverlagerung des Haltekörpers 23 relativ zu dem Grundkörper und/oder zu dem Basiskörper 40 erreicht wird.

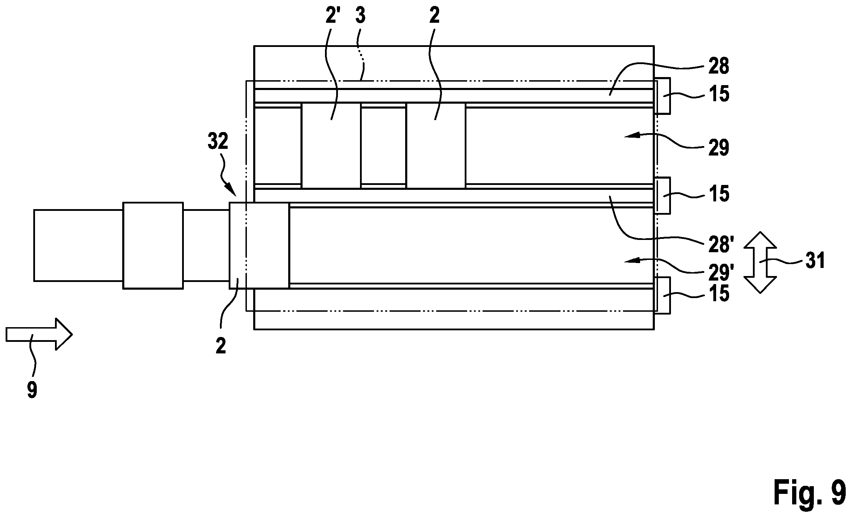

Die Trageinrichtung 11 kann beispielsweise parallel zu der Verlagerungsbewegung 9 verlaufende und/oder parallel zueinander ausgerichtete Wandkörper 28 umfassen, vgl. Figuren 8 und 9. Hierbei kann beispielsweise zwischen zwei Wandkörpern 28, 28' eine Aufnahmespur 29, 29' zur Aufnahme wenigstens einer Baugruppe 2, 2', insbesondere einer ersten Gruppe an Baugruppen 2, 2', ausgebildet werden. Bevorzugt entspricht ein Abstand 30 der Wandkörper 28 zumindest annähernd dem in Querrichtung zur Verlagerungsbewegung 9 vorliegendem Längenmaß bzw. Breitenmaß der wenigstens einen Baugruppe 2, 2'. Es kann vorgesehen sein, dass an den Wandkörpern 28, 28' die Lagerungs- und/oder Tragmittel 10, 10', 13 zum Tragen der wenigstens eine Baugruppe 2, 2' angeordnet oder ausgebildet sind. Die Wandkörper 28, 28' können damit einen Bestandteil der Trageinrichtung 11 ausbilden.

Die Trageinrichtung 11 kann beispielsweise wenigstens eine Aufnahmespur 29, 29' zur tragenden Aufnahme wenigstens einer Baugruppe 2, 2' aufweist, wobei die Aufnahmespurbreite bzw. der Abstand 30 zwischen zwei Wandkörpern 28, 28' veränderbar, insbesondere durch einen Motor veränderbar, ist. Die Wandkörper 28, 28' können beispielsweise nach Art einer Parallelverschiebung zueinander in Ihrem Abstand 30 verändert werden und damit an eine ggf. sich ändernde Breite der Baugruppen 2, 2' angepasst werden. Eine Aufnahmespur 29 meint hierbei, dass ein, insbesondere geradliniger, Aufnahmekanal ausgebildet wird, in welchem wenigstens eine Baugruppe 2, 2' bevorzugt mindestens zwei Baugruppen 2, 2' aufgenommen werden kann bzw. können.

Die Trageinrichtung 11 kann beispielsweise rechtwinklig zur Verlagerungsbewegung 9 der wenigstens einen Baugruppe 2, 2' zur Ausführung einer Ausrichtbewegung 31, und insbesondere parallel zu einer Haupterstreckungsebene der Trageinrichtung 11, verfahrbar sein bzw. verfahren werden. In den Figuren 8 und 9 sind zwei durch das Ausführen einer Ausrichtbewegung 31 einnehmbare Positionen dargestellt. Dabei ist vermittels der Ausrichtbewegung 31 wahlweise eine erste Aufnahmespur 29 der Trageinrichtung 11 zur Aufnahme von wenigstens einer Baugruppe 2, 2' und wenigstens eine zweite Aufnahmespur 29' der Trageinrichtung 11 zur Aufnahme von wenigstens einer weiteren Baugruppe 2, 2' zu einem, insbesondere einspurigen, Einbringbereich 32 zur Einbringung von wenigstens einer Baugruppe 2 zur Trageinrichtung 11 bzw. in den Bereitstellungsbereich 3 in eine korrespondierende Ausrichtung und/oder Position verfahrbar. In der in Figur 8 dargestellten Position ist die erste Aufnahmespur 29 korrespondierend zu dem Einbringbereich 32 zur Aufnahme einer Baugruppe 2 aus diesem Einbringbereich 32 positioniert. In Figur 9 ist die Trageinrichtung 11 gemäß der Ausrichtbewegung 31 verfahren, derart, dass die weitere Aufnahmespur 29' der Trageinrichtung 11 korrespondierend zu dem Einbringbereich 32 positioniert ist, sodass eine aus dem Einbringbereich 32 sich in Richtung der Trageinrichtung 11 bewegende Baugruppe 2 in der weiteren Aufnahmespur 29' aufgenommen wird.

Der Einbringbereich 32 kann eine Einbringeinrichtung umfassen, welche eingerichtet ist, Baugruppen 2 von einem von der Vorrichtung 1 entfernt gelegenen Ort zu der Trageinrichtung 11 zu verlagern bzw. derart in oder an die Trageinrichtung 11 heranzuführen, dass eine Übergabe der Baugruppen 2, 2' von dem Einbringbereich 32 zu der Trageinrichtung 11, insbesondere in oder an einen Bereitstellungsbereich 3 der Trageinrichtung 11, erfolgen kann.

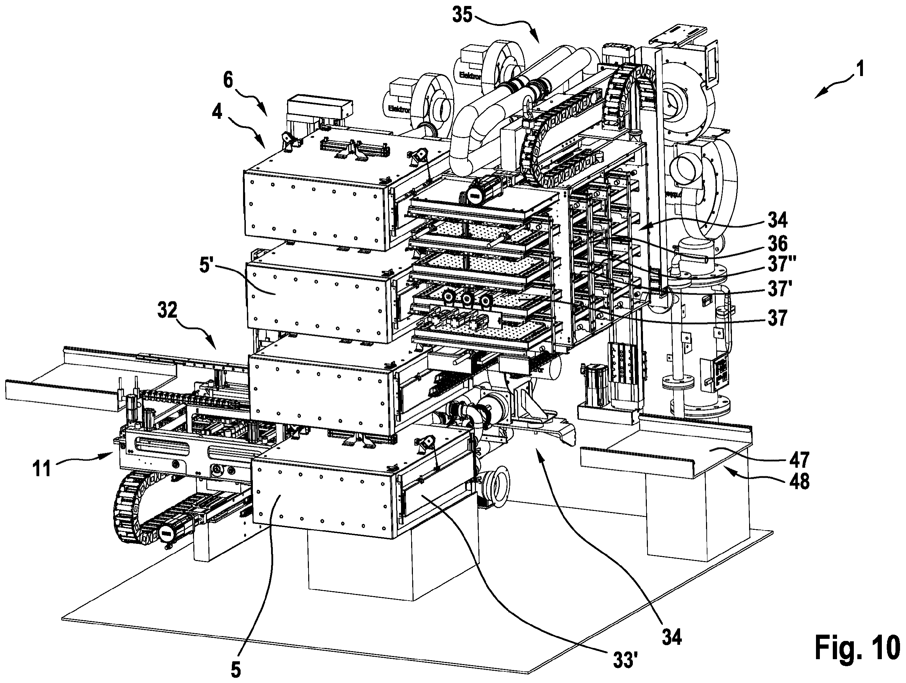

Eine Prozesskammereinrichtung 6 kann beispielsweise mit wenigstens zwei übereinander angeordneten Prozesskammern 5, 5' ausgestattet sein, wobei die Trageinrichtung 11 bzw. zumindest Bestandteile dieser, derart höhenverlagerbar ist bzw. sind, dass wenigstens eine von der Trageinrichtung 11 getragene Baugruppe 2 wahlweise in eine erste oder eine weitere Prozesskammer 5, 5' der Prozesskammereinrichtung 6 verlagerbar bzw. überführbar ist, vgl. Figur 1. Hierzu kann die Trageinrichtung 11 oder ein die Lagerungsmittel 10, 10' bzw. die Tragmittel 13 umfassender Bestandteil der Trageinrichtung 11 höhenverlagerbar sein. In der in Figur 10 gezeigten Ausführungsform der Vorrichtung 1 weist diese vier übereinander, insbesondere sich in der Draufsicht deckend, angeordnete Prozesskammern 5, 5' auf. Die Trageinrichtung 11 ist dabei in der Höhe verfahrbar, sodass durch das Anfahren einer vordefinierten Höhenposition jeweils ein Übergeben einer Baugruppe zwischen der Trageinrichtung 11 und der Prozesskammer 5, 5' ausführbar ist.

Eine Prozesskammereinrichtung 6 kann beispielsweise mit wenigstens einer Prozesskammer 5, 5' ausgestattet sein, wobei wenigstens eine Prozesskammer 5, 5' eine erste und eine weitere Übergabeöffnung 33, 33' aufweist. Die Übergabeöffnungen 33, 33' dienen zum Hindurchführen bzw. zum Bewegen wenigstens einer Baugruppe 2, 2' zwischen (a) einem prozesskammerseitigen Arbeitsbereich 4 und (b1) einem trageinrichtungsseitigen Bereitstellungsbereich 3 und/oder (b2) einem sammeleinrichtungsseitigen Sammelbereich 35. Die Übergabeöffnungen 33, 33' können an zwei gegenüberliegenden Seitenflächen der wenigstens einen, insbesondere quaderartigen, Prozesskammer 5 angeordnet oder ausgebildet sein. Bevorzugt sind eine erste Gruppe an Übergabeöffnungen 33 jeweiliger Prozesskammern 5, 5' an einer ersten Seitenfläche der Prozesskammern 5, 5' und eine weitere Gruppe weiterer Übergabeöffnungen 33' jeweiliger Prozesskammern 5, 5' an einer weiteren, insbesondere zur ersten Seitenfläche gegenüberliegenden, Seitenfläche der Prozesskammern 5, 5' angeordnet oder ausgebildet. Mit anderen Worten sind die Übergabeöffnungen 33, 33' zum Bereitstellungsbereich 3 oder zum Sammelbereich 35 mehrerer, insbesondere sämtlicher, Prozesskammern 5, 5' einer Vorrichtung 1 an den gleichen Seiten der Prozesskammereinrichtung angeordnet oder ausgebildet.

Die Übergabeöffnungen 33, 33' der Prozesskammern 5, 5' können jeweils vermittels Verschlussmittel 42 verschließbar sein bzw. temporär verschlossen werden. Dies ist vorteilhaft, um eine gezielte Temperierung einer Baugruppe 2 in einem Innenraum bzw. im Arbeitsbereich 4 einer Prozesskammer 5, 5' zu ermöglichen. Auch kann der Energieaufwand für die Temperierung des Innenraums bzw. des Arbeitsbereichs 4 reduziert und/oder eine höhere Genauigkeit bei der Temperierung des Innenraums bzw. des Arbeitsbereichs 4 der Prozesskammer 5, 5' und/oder der in dem Innenraum platzierten Baugruppe 2, 2' erreicht werden.

Wie insbesondere aus Figur 10 ersichtlich, kann die Vorrichtung 1 eine Sammeleinrichtung 34 umfassen, wobei die Sammeleinrichtung 34 einen Sammelträger 36 umfasst, welcher, insbesondere horizontal und/oder vertikal, verfahrbar relativ zu der Prozesskammereinrichtung 6 ist, um wenigstens eine aus der wenigstens einen Prozesskammer 5, 5' herausbewegte Baugruppe 2, bevorzugt unmittelbar, aufzunehmen. Bevorzugt weist die Sammeleinrichtung 34, insbesondere der Sammelträger 36, mehrere, bevorzugt übereinander und/oder nebeneinander angeordnete oder ausgebildete, Gruppen von Aufnahmespuren 37, 37', 37" auf. So können Aufnahmespuren 37, 37', 37" nebeneinander und/oder übereinander angeordnet oder ausgebildet sein. Damit wird die Lagerung bzw. das Sammeln bzw. das zeitweise Aufnehmen einer Vielzahl an Baugruppen 2, 2' unter Verwendung eines geringen Volumens und/oder unter einem geringen Flächenbedarf der Vorrichtung 1 in einer Werkshalle ermöglicht. Der Sammelträger 36 ist derart verfahrbar, dass eine definierte Aufnahmespur 37, 37', 37" gezielt zu einer bzw. durch eine Übergabeöffnung 33' einer Prozesskammer 5, 5' derart verfahren werden kann, um eine Baugruppe 2, 2' zwischen der sammelträgerseitigen Aufnahmespur 37, 37', 37" und dem Arbeitsbereich 4 der Prozesskammer 5, 5' bewegt wird. Die Sammeleinrichtung 34 kann als Speicher von wenigstens einer Baugruppe 2, 2' und/oder als eine Reihenfolge der bewegten Baugruppen 2, 2' änderndes Mittel und/oder als Abkühlbereich zur aktiven und/oder passiven Abkühlung der wenigstens einen Baugruppe 2, 2' eingesetzt werden. Die Sammeleinrichtung kann die in dieser aufgenommenen Baugruppen 2, 2' an einen an die Vorrichtung 1 angrenzenden Abführbereich 48 einer Abführeinrichtung 47 übergeben. Hierzu kann die Sammeleinrichtung 34 und/oder die Abführeinrichtung 47 optional Mittel aufweisen, welche eine Verlagerung der Baugruppen 2, 2' ermöglicht.

Es ist möglich, dass die Sammeleinrichtung 34 derart ausgebildet ist, dass diese zumindest abschnittsweise, bevorzugt überwiegend, besonders bevorzugt vollständig, die in ihr aufgenommenen Baugruppen 2, 2' mit einer definierten Gasatmosphäre, insbesondere einer Inertgasatmosphäre, umgibt. So ist es möglich, dass die Sammeleinrichtung 34 ein zumindest temporär gasdicht abschließbares Aufnahmevolumen aufweist, in welchem eine definierte Gasatmosphäre, insbesondere eine Inertgasatmosphäre, herrscht und/oder aufgebaut werden kann, sodass die in diesem Aufnahmevolumen aufgenommenen Baugruppen 2, 2' einer entsprechenden Gasatmosphäre ausgesetzt sind.

Der Prozess der Zuführung der Baugruppen 2, 2' in die Prozesskammer und die Verweildauer der Baugruppen 2, 2' in dieser Prozesskammer sowie die Ansteuerung einer aktiven Kühleinrichtung in oder an der Sammeleinrichtung zur aktiven Kühlung der in der Sammeleinrichtung befindlichen Baugruppen 2, 2' und/oder die Ansteuerung der Sammeleinrichtung zur definierten Verweildauer der Baugruppen in der Sammeleinrichtung zur aktiven oder passiven Abkühlung der Baugruppen 2, 2', während diese in der Sammeleinrichtung 34 aufgenommen sind, kann definiert vorgegeben werden. Die Sammeleinrichtung 34 kann eine Kühleinrichtung (nicht dargestellt) umfassen und/oder eine Kühleinrichtung der Sammeleinrichtung 34 zugeordnet sein, sodass eine zumindest temporäre aktive Abkühlung der in der Sammeleinrichtung 34 platzierten Baugruppe(n) 2, 2' vermittels der Kühleinrichtung ausführbar ist.

So ist es beispielsweise möglich, dass durch die Sammeleinrichtung 34 und die Reihenfolge oder eine erfolgende Aufnahme von Baugruppen 2, 2' in dieser Sammeleinrichtung 34 die Abkühlzeit der Baugruppen 2, 2' gezielt beeinflusst werden kann. Sofern die Anzahl der Aufnahmeplätze für Baugruppen 2, 2' in dem Arbeitsbereich 4 der Prozesskammer 6 identisch mit dem der Sammeleinrichtung 34 ist, kann die Heizdauer der Kühldauer entsprechen. So kann beispielsweise auch ein Modus gefahren werden, bei welchem die Sammeleinrichtung gegenüber der Prozesskammer 6 einen Überschuss an Aufnahmeplätzen für Baugruppen 2, 2' aufweist, sodass dieser Überschuss, quasi als Dispositionsvolumen oder Puffervolumen, zur gezielten Verweildauerverlängerung für die Baugruppen 2, 2' innerhalb der Sammeleinrichtung 34 im Vergleich zu der Verweildauer innerhalb des Arbeitsbereichs genutzt werden kann.

In der Zusammenschau der Figuren 2 und 3 ist erkennbar, dass eine erste Baugruppe 2, welche in Richtung der Verlagerungsbewegung 9 vorne, bzw. dem Prozesskammereinrichtung 6 näher zugewandt ist als eine weitere, benachbarte Baugruppe 2', aufgrund des in der Sperrposition 16 befindlichen Rückhaltemittels 15 in einer Warteposition verbleibt, während die weitere, benachbarte Baugruppe 2' weitertransportiert wird, vermittels einer Förderwirkung durch die Bewegung des Tragmittels 13, insbesondere der Lagerungsmittel 10, 10', der Trageinrichtung 11. Hierbei führen etwaige Lagerungsmittel 10, 10', welche die erste Baugruppe 2 abstützen (hier: entgegen des Uhrzeigersinns gerichtet) eine um die Rotationsachsen 20 erfolgende Drehbewegung 25 aus. Somit kann während der sonstigen Bewegung des Verlagerungsmittels 7, insbesondere des Verlagerungselements 24, auch ohne Einfluss dieses eine kompakte Anordnung der Baugruppen 2, 2' an bzw. auf der Trageinrichtung 11 erreicht werden. In Figur 3 ist die Relativbewegung der wenigstens zwei Baugruppen 2, 2' beendet, sodass diese durch, insbesondere unmittelbaren Kontakt zueinander angeordnet sind. Die Drehbewegung 25 bei Wirksamkeit des Rückhaltemittels 15 (d. h. Rückhaltemittel 15 in Sperrposition) kann entgegengesetzt zur Drehbewegung 21 während einer zugelassenen Schiebebewegung durch das Verlagerungselement 24 (d. h. Rückhaltemittel 15 in Freigabeposition) erfolgen.

Alternativ oder zusätzlich kann es vorgesehen sein, dass zumindest wie Baugruppen 2, 2' nicht unmittelbar sich berühren, sondern zwischen zwei Baugruppen 2, 2' ein Verlagerungselement 24 oder ein weiteres beweglich gelagertes Element (nicht dargestellt) bewegt bzw. platziert werden kann. Mit anderen Worten kann das Verlagerungselement 24 zwischen zwei Baugruppen 2, 2' positioniert werden, wobei das Verlagerungselement 24 in die Ebene der Baugruppe 2, 2' bewegt wird und dort als Anschlag für wenigstens eine Baugruppe 2, 2' dient. So kann die weitere Baugruppe 2' vermittels der Ringbewegung bzw. der fließbandartigen Bewegung der Lagerungsmittel 10, 10' in Bewegung versetzt werden und durch das entsprechend angeordnete Verlagerungselement 24 als Anschlag bzw. als Rückhaltemittel für diese weitere Baugruppe 2' dienen. Damit erhält das Verlagerungselement 24 neben seiner Verlagerungsfunktion durch eine Schiebebewegung auf eine Baugruppe 2, 2' zusätzlich eine Stopperfunktion bzw. Anschlagsfunktion zur Ausbildung eine Anordnung von Baugruppen 2, 2' auf Lücke, insbesondere innerhalb des Bereitstellungsbereichs 3 und/oder des Arbeitsbereichs 4 der Prozesskammer 5 und/oder der Sammeleinrichtung 34. In einem nächsten Schritt kann die Ringbewegung bzw. die fließbandartige Bewegung der Lagerungsmittel 10, 10' gestoppt werden, sodass keine durch diese Bewegung resultierende Förderung der weiteren Baugruppe 2' mehr erfolgt. Folglich kann damit das Verlagerungselement 24 aus dem Zwischenraum der beiden Baugruppen 2, 2' herausgefahren werden, wobei der Zwischenraum bestehen bleibt. Dies hat den Vorteil, dass eine mechanische Beeinflussung oder eine thermische Beeinflussung durch einen etwaigen Kontakt der beiden Baugruppen 2, 2' zueinander verhindert wird. Auch kann der bestehende Zwischenraum zur Einbringung des Verlagerungselements 24 verwendet werden, um so eine definierte Bewegung bzw. ein definiertes Verschieben einer einzelnen Baugruppe 2, 2', insbesondere der weiteren Baugruppe 2', auszuführen.

Ein mit einem Zwischenraum versehenes Anordnen bzw. ein auf Lücke erfolgendes Anordnen der Baugruppen 2, 2' kann für deren Platzierung (a) in oder an dem Bereitstellungsbereich 3, insbesondere in oder an einer Trageinrichtung 11, und/oder (b) in dem Arbeitsbereich 4 einer Prozesskammer 5 und/oder (c) in oder an einer Sammeleinrichtung 34. insbesondere in einem Sammelträger 36 und/oder einer Aufnahmespur 37, 37', 37" einer Sammeleinrichtung 34, dienen. So kann das Verlagerungselement 24 gezielt in die vorher gebildeten Lücken bzw. Zwischenräume der Baugruppen 2, 2' hineinbewegt werden, um anschließend wenigstens eine Baugruppe 2, 2' ausgehend von der Positionierung der Verlagerungseinrichtung 24 in dieser Lücke durch Schieben definiert zu bewegen bzw. zu verschieben.

Es kann vorgesehen sein, dass die Vorrichtung 1 wenigstens zwei oder mehr Verlagerungselemente 24 umfasst, welche unabhängig voneinander bewegbar gelagert sind, sodass diese mehreren Verlagerungselemente 24 jeweils in einen Zwischenraum bzw. zur Ausbildung mehrerer Zwischenräume zwischen mehreren Baugruppen 2, 2' verwendet werden können. So kann jedes Verlagerungselement 24 als zwischenraumbildendes Element zur Ausbildung von jeweils einem Zwischenraum zwischen mehreren Baugruppen 2, 2' eingesetzt werden

Es ist möglich, dass das Verlagerungsmittel 7 eingerichtet ist, (a) eine in einem trageinrichtungsseitigen Bereitstellungsbereich 3 angeordnete Baugruppe 2, 2' in einen prozesskammerseitigen Arbeitsbereich 4 und/oder (b) eine in einem prozesskammerseitigen Arbeitsbereich 4 angeordnete Baugruppe 2, 2' in einen trageinrichtungsseitigen Bereitstellungsbereich 3 und/oder (c) eine in einem prozesskammerseitigen Arbeitsbereich 4 angeordnete Baugruppe 2, 2' in einen sammeleinrichtungsseitigen Sammelbereich 35 und/oder (d) eine in einem sammeleinrichtungsseitigen Sammelbereich 35 angeordnete Baugruppe 2, 2' in einen prozesskammerseitigen Arbeitsbereich 4 zu bewegen. Insbesondere wird zumindest eine, insbesondere sämtliche, der vorgenannten Bewegungen der wenigstens einen Baugruppe 2, 2' durch Kontakt und Aufbringen einer Druckkraft 8 auf die wenigstens eine Baugruppe 2, 2' vermittels des verlagerungsmittelseitigen Verlagerungselements 24 ausgeführt.

Das Verlagerungsmittel 7 kann beispielsweise derart eingerichtet sein, dass eine Bewegung einer Baugruppe 2, 2' (a) an einem und/oder über einen Spalt (19) zwischen dem trageinrichtungsseitigen Bereitstellungsbereich 3 und dem prozesskammerseitigen Arbeitsbereich 4 und/oder (b) an einem und/oder über einen Spalt (19) zwischen dem prozesskammerseitigen Arbeitsbereich 4 und dem sammeleinrichtungsseitigen Sammelbereich 35 und/oder (c) innerhalb des Arbeitsbereichs 4 und/oder (d) innerhalb des Bereitstellungsbereichs 3, ausschließlich durch die, bevorzugt unmittelbar berührende, Einwirkung des Verlagerungsmittels 7 bzw. des Verlagerungselements 24 erfolgt.

In einer weiteren vorteilhaften Ausführungsform kann es vorgesehen sein, dass (a) das Verlagerungsmittel 7 zumindest teilweise zu der Trageinrichtung 11 und/oder (b) das Verlagerungselement 24 zu dem Haltekörper 23 und/oder (c) der Haltekörper 23 zu dem Grundkörper des Verlagerungsmittels 7 und/oder zu der Trageinrichtung 11, insbesondere zu dem Basiskörper 40 der Trageinrichtung, und/oder (d) das wenigstens eine Lagerungsmittel 10, 10' innerhalb der Trageinrichtung 11 und/oder (e) das Lagerungsmittel 10, 10' um eine lagerungsmittelseitige Rotationsachse 20 und/oder (f) eine Sammeleinrichtung 34 vermittels eines Motors verfahrbar bzw. bewegbar ist. Es kann hierbei beispielsweise ein Motor für eine gleichzeitige oder selektive Ausführung wenigstens zweier, insbesondere sämtlicher, der genannten Relativbewegungen verwendet werden. Alternativ kann zumindest für einen Teil, insbesondere für sämtliche, der genannten Relativbewegungen von Bestandteilen der Vorrichtung 1, insbesondere von Bestandteilen des Verlagerungsmittels 7, jeweils ein eigener, bevorzugt unabhängig zu weiteren Motoren ansteuerbarer, Motor verwendet werden.

### BEZUGSZEICHENLISTE

- 1: Vorrichtung
- 2, 2': Baugruppe
- 3: Bereitstellungsbereich
- 4: Arbeitsbereich
- 5, 5': Prozesskammer
- 6: Prozesskammeinrichtung
- 7: Verlagerungsmittel
- 8: Kraft
- 9: Verlagerungsbewegung
- 10, 10': Lagerungsmittel
- 11: Trageinrichtung
- 12: erster Abschnitt von 9
- 13: Tragmittel
- 14: weiterer Abschnitt von 9
- 15: Rückhaltemittel
- 16: Sperrposition
- 17: Freigabeposition
- 18: Abstützbereich von 15
- 19: Spalt zw. 5 und 11
- 20: Rotationsachse
- 21: Drehbewegung von 10, 10'
- 22: Verbindungsglied
- 23: Haltekörper
- 24: Verlagerungselement
- 25: Drehbewegung von 10, 10'
- 27: Auszugsposition
- 28, 28': Wandkörper
- 29, 29': Aufnahmespur von 11
- 30: Abstand
- 31: Ausrichtbewegung von 11
- 32: Einbringbereich
- 33, 33': Übergabeöffnung von 5, 5'
- 34: Sammeleinrichtung
- 35: Sammelbereich
- 36: Sammelträger
- 37, 37', 37": Aufnahmespur von 34
- 38: Ringbahn
- 40: Basiskörper
- 41: Traverse
- 42: Verschlussmittel
- 43: Pfeil
- 44: Antriebsrad
- 45: Säulenkörper
- 46: Auszugkörper
- 47: Abführeinrichtung
- 48: Abführbereich

## Patentansprüche

1. Vorrichtung (1) zur Verlagerung wenigstens einer Baugruppe (2, 2') zwischen einem Bereitstellungsbereich (3) und einem Arbeitsbereich (4) wenigstens einer Prozesskammer (5) einer Prozesskammereinrichtung (6) zum Reflow-Löten, mit wenigstens einem Verlagerungsmittel (7), wobei die wenigstens eine Baugruppe (2, 2') vermittels einer von dem Verlagerungsmittel (7) übertragenen oder erzeugten, auf die Baugruppe (2, 2') einwirkenden Kraft (8) zumindest abschnittsweise eine Verlagerungsbewegung (9) derart ausführt oder eine derartige Verlagerungsbewegung (9) ausführbar ist, dass die wenigstens eine Baugruppe (2, 2') verlagert wird, umfassend
eine wenigstens ein Lagerungsmittel (10, 10') umfassende Trageinrichtung (11), wobei die wenigstens eine Baugruppe (2, 2') zumindest abschnittsweise während der Verlagerungsbewegung (9) auf dem Lagerungsmittel (10, 10') anordenbar oder angeordnet ist und vermittels dem Lagerungsmittel (10, 10') zumindest in Richtung der Verlagerungsbewegung (9) beweglich und/oder bewegbar an der Trägereinrichtung (11) gelagert ist, **dadurch gekennzeichnet, dass**
an einem Endbereich der Trageinrichtung (11) zumindest ein Rückhaltemittel (15) anordenbar oder angeordnet ist, das zwischen einer Sperrposition (16) und einer Freigabeposition (17) bewegbar ist, wobei in der Sperrposition (16) eine Bewegung von wenigstens einer von der Trageinrichtung (11) getragenen Baugruppe (2, 2') in Richtung der Verlagerungsbewegung (9) gehemmt und in der Freigabeposition (17) eine Bewegung von wenigstens einer von der Trageinrichtung (11) getragenen Baugruppe (2, 2') in Richtung der Verlagerungsbewegung (9) freigegeben wird.

2. Vorrichtung (1) nach Anspruch 1, **dadurch gekennzeichnet, dass** die wenigstens eine Baugruppe (2, 2') zumindest abschnittsweise, bevorzugt überwiegend, während der Verlagerungsbewegung (9) auf dem Lagerungsmittel (10, 10') unmittelbar anordenbar oder angeordnet ist und vermittels dem Lagerungsmittel (10, 10') zumindest in Richtung der Verlagerungsbewegung (9) beweglich und/oder bewegbar an der Trägereinrichtung (11) gelagert ist.

3. Vorrichtung (1) nach Anspruch 1 oder 2, **dadurch gekennzeichnet, dass** die Vorrichtung (1) eingerichtet ist, in einem ersten Abschnitt der Verlagerungsbewegung (9) eine Verlagerung der wenigstens einen Baugruppe (2, 2') zumindest durch eine Bewegung eines die wenigstens eine Baugruppe (2, 2') zumindest abschnittsweise tragenden Tragmittels (13), insbesondere eines Lagerungsmittels (10, 10'), der Trageinrichtung (11) und in einem weiteren Abschnitt der Verlagerungsbewegung (9) eine Verlagerung der wenigstens einen Baugruppe (2, 2') zumindest durch die Einwirkung der vermittels dem Verlagerungsmittel (7) auf die wenigstens eine Baugruppe (2, 2') einwirkenden Kraft (8) ausgeführt wird.

4. Vorrichtung (1) nach einem der vorhergehenden Ansprüche, **dadurch gekennzeichnet, dass** das zumindest eine Rückhaltemittel (15) einen Abstützbereich (18) zum zumindest temporären Abstützen von zumindest einer während wenigstens eines Abschnitts der Verlagerungsbewegung (9) bewegten Baugruppe (2, 2') umfasst, bevorzugt ist das zumindest eine Rückhaltemittel (15) derart angeordnet oder ausgebildet, dass das zumindest eine Rückhaltemittel (15) zumindest in der Freigabeposition (17) eine von der wenigstens einen Baugruppe (2, 2') zu passierende Unterbrechung eines Kontaktbereichs der Baugruppe (2, 2') mit der Trageinrichtung (11) und der Prozesskammer (5, 5') reduziert.

5. Vorrichtung (1) nach einem der vorhergehenden Ansprüche, **dadurch gekennzeichnet, dass** die Vorrichtung (1) eingerichtet ist, in zumindest einem Abschnitt der Verlagerungsbewegung (9) die wenigstens eine Baugruppe (2, 2') vermittels einer überlagerten Einwirkung einer durch das Verlagerungsmittel (7) auf die wenigstens eine Baugruppe (2, 2') einwirkenden Kraft (8) und einer Bewegung des die wenigstens eine Baugruppe (2, 2') tragenden Tragmittels (13), insbesondere zumindest eines Lagerungsmittels (10, 10'), einer Trageinrichtung (11) zu bewegen.

6. Vorrichtung (1) nach einem der vorhergehenden Ansprüche, **gekennzeichnet durch** wenigstens ein um eine, insbesondere senkrecht zur Verlagerungsbewegung (9) ausgerichteten, Rotationsachse (20) drehbar gelagertes Lagerungsmittels (10, 10'), wobei bevorzugt zumindest ein Bestandteil der Verlagerungsbewegung (9) der wenigstens einen auf einem Lagerungsmittel (10, 10') angeordneten Baugruppe (2, 2') aufgrund der Einwirkung des Verlagerungsmittels (7) auf die wenigstens eine Baugruppe (2, 2') unter Drehbewegung (21) des wenigstens einen drehbar gelagerten Lagerungsmittels (10, 10') um die Rotationsachse (20) ausführbar ist.

7. Vorrichtung (1) nach einem der vorhergehenden Ansprüche, **dadurch gekennzeichnet, dass** wenigstens zwei Lagerungsmittel (10, 10') über ein Verbindungsglied (22) verbunden sind und zumindest abschnittsweise in Richtung der Verlagerungsbewegung (9) bewegbar, insbesondere motorisch antreibbar, sind, bevorzugt ist die Vorrichtung (1) eingerichtet, dass wenigstens zwei Lagerungsmittel (10, 10') eine zumindest abschnittsweise lineare Transportbewegung in Richtung der Verlagerungsbewegung (9) ausführen, in welcher eine auf diesen Lagerungsmitteln (10, 10') angeordnete Baugruppe (2, 2') zumindest einen Bestandteil einer, insbesondere linearen, Verlagerungsbewegung (9) ausführt.

8. Vorrichtung (1) nach einem der vorhergehenden Ansprüche, **dadurch gekennzeichnet, dass** das wenigstens eine Verlagerungsmittel (7) zumindest ein an einem verlagerungsmittelseitigen Haltekörper (23) bewegbar gelagertes Verlagerungselement (24) zum zumindest temporären Kontakt mit wenigstens einer Baugruppe (2, 2') umfasst, wobei das Verlagerungselement (24) zumindest abschnittsweise parallel und/oder senkrecht zur Verlagerungsbewegung (9) bewegbar ist, wobei optional der Haltekörper (23) bewegbar an einem Grundkörper des Verlagerungsmittels (7) und/oder an der Trageinrichtung (11) befestigbar oder befestigt ist, bevorzugt ist der Haltekörper (23) senkrecht und/oder parallel bewegbar zu einer Haupterstreckungsebene des Haltekörpers (23) und/oder zu einer Haupterstreckungsebene des Grundkörpers und/oder zu einer Haupterstreckungsebene der Trageinrichtung (11), wobei optional der Haltekörper (23) und/oder ein beweglich an dem Haltekörper gelagerter Auszugkörper (46) zwischen einer ersten, mit dem Grundkörper und/oder mit einem Basiskörper (40) der Trageinrichtung (11) zumindest überwiegend, insbesondere vollständig, in Deckung stehenden Deckungsposition und einer zweiten, seitlich versetzt zu dem Grundkörper und/oder zu dem Basiskörper (40) der Trageinrichtung (11) positionierten Auszugsposition (27), bevorzugt motorisch angetrieben, verfahrbar bzw. ausziehbar ist.

9. Vorrichtung (1) nach einem der vorhergehenden Ansprüche, **dadurch gekennzeichnet, dass** die Trageinrichtung (11) parallel zu der Verlagerungsbewegung (9) verlaufende und parallel zueinander ausgerichtete Wandkörper (28, 28') umfasst, wobei zwischen zwei Wandkörpern (28, 28') eine Aufnahmespur (29, 29') zur Aufnahme wenigstens einer Baugruppe (2, 2'), insbesondere eine erste Gruppe an Baugruppen (2, 2'), ausgebildet wird, bevorzugt entspricht der Abstand (30) der Wandkörper (28, 28') zumindest annähernd dem in Querrichtung zur Verlagerungsbewegung (9) vorliegendem Längenmaß der wenigstens einer Baugruppe (2, 2').

10. Vorrichtung (1) nach einem der vorhergehenden Ansprüche, **dadurch gekennzeichnet, dass** die Trageinrichtung (11) wenigstens eine Aufnahmespur (29, 29') zur tragenden Aufnahme wenigstens einer Baugruppe (2, 2') aufweist, wobei wenigstens eine Aufnahmespurbreite zumindest einer Aufnahmespur (29, 29') veränderbar, insbesondere durch einen Motor veränderbar, ist; und/oder
**dass** die Trageinrichtung (11) rechtwinklig zur Verlagerungsbewegung (9) der wenigstens einen Baugruppe (2, 2'), insbesondere parallel zu einer Haupterstreckungsebene der Trageinrichtung (11), zur Ausführung einer Ausrichtbewegung (31) verfahrbar ist, bevorzugt ist vermittels der Ausrichtbewegung (31) wahlweise eine erste Aufnahmespur (29) der Trageinrichtung (11) zur Aufnahme von wenigstens einer Baugruppe (2, 2') und wenigstens eine zweite Aufnahmespur (29') der Trageinrichtung (11) zur Aufnahme von wenigstens einer weiteren Baugruppe (2, 2') zu einem, insbesondere einspurigen, Einbringbereich (32) zur Einbringung von wenigstens einer Baugruppe (2, 2') zur Trageinrichtung (11) in eine korrespondierende Ausrichtung und/oder Position verfahrbar.

11. Vorrichtung (1) nach einem der vorhergehenden Ansprüche, **gekennzeichnet durch** eine Prozesskammereinrichtung (6) mit wenigstens zwei übereinander angeordneten Prozesskammern (5, 5'), wobei die Trageinrichtung (11) derart höhenverlagerbar ist, dass wenigstens eine von der Trageinrichtung (11) getragene Baugruppe (2, 2') wahlweise in eine erste oder eine weitere Prozesskammer (5, 5') der Prozesskammereinrichtung (6) verlagerbar ist; und/oder
**durch** eine Prozesskammereinrichtung (6) mit wenigstens einer Prozesskammer (5, 5'), wobei wenigstens eine Prozesskammer (5, 5') eine erste und eine weitere Übergabeöffnung (33, 33') zum Hindurchführen wenigstens einer Baugruppe (2, 2') zwischen einem prozesskammerseitigen Arbeitsbereich (4) und einem trageinrichtungsseitigen Bereitstellungsbereich 3 und/oder einem sammeleinrichtungsseitigen Sammelbereich (35) aufweist, wobei die Übergabeöffnungen (33, 33') bevorzugt an zwei gegenüberliegenden Seitenflächen der, insbesondere quaderartigen, Prozesskammer (5) angeordnet oder ausgebildet sind; und/oder
**durch** eine Prozesskammereinrichtung (6) mit wenigstens einer Prozesskammer (5) sowie einer Sammeleinrichtung (34), wobei die Sammeleinrichtung (34) einen Sammelträger (36) umfasst, welcher horizontal und/oder vertikal verfahrbar ist, um wenigstens eine aus der Prozesskammer (5, 5') herausbewegte Baugruppe (2, 2') aufzunehmen, bevorzugt weist die Sammeleinrichtung (34) mehrere, insbesondere übereinander angeordnete oder ausgebildete, Gruppen von Aufnahmespuren 37, 37', 37" auf.

12. Vorrichtung (1) nach einem der vorhergehenden Ansprüche, **dadurch gekennzeichnet, dass** das Verlagerungsmittel (7) eingerichtet ist,
- eine in einem trageinrichtungsseitigen Bereitstellungsbereich (3) angeordnete Baugruppe (2, 2') in einen prozesskammerseitigen Arbeitsbereich (4) und/oder
- eine in einem prozesskammerseitigen Arbeitsbereich (4) angeordnete Baugruppe (2, 2') in einen trageinrichtungsseitigen Bereitstellungsbereich (3) und/oder
- eine in einem prozesskammerseitigen Arbeitsbereich (4) angeordnete Baugruppe (2, 2') in einen sammeleinrichtungsseitigen Sammelbereich (35) und/oder
- eine in einem sammeleinrichtungsseitigen Sammelbereich (35) angeordnete Baugruppe (2, 2') in einen prozesskammerseitigen Arbeitsbereich (4)
zu bewegen, insbesondere erfolgt die Bewegung der Baugruppe (2, 2') durch Kontakt und Aufbringen einer Kraft, bevorzugt einer Druckkraft (8), auf wenigstens eine Baugruppe (2, 2') durch ein verlagerungsmittelseitiges Verlagerungselement (24) des Verlagerungsmittels (7) zu bewegen.

13. Vorrichtung (1) nach einem der vorhergehenden Ansprüche, **dadurch gekennzeichnet, dass** das Verlagerungsmittel (7) derart eingerichtet ist, dass eine Bewegung einer Baugruppe (2, 2')
- an einem und/oder über einen Spalt (19) zwischen dem trageinrichtungsseitigen Bereitstellungsbereich (3) und dem prozesskammerseitigen Arbeitsbereich (4) und/oder
- an einem und/oder über einen Spalt zwischen dem prozesskammerseitigen Arbeitsbereich (4) und dem sammeleinrichtungsseitigen Sammelbereich (35) und/oder
- innerhalb des Arbeitsbereichs (4) und/oder
- innerhalb des Bereitstellungsbereichs (4)
zumindest abschnittsweise, insbesondere vollständig, ausschließlich, durch die Einwirkung des Verlagerungsmittels (7) erfolgt.

14. Vorrichtung (1) nach einem der vorhergehenden Ansprüche, **dadurch gekennzeichnet, dass**
- das Verlagerungsmittel (7) zumindest teilweise zu der Trageinrichtung (11) und/oder
- das Verlagerungselement (24) zu dem Haltekörper (23) und/oder
- der Haltekörper (23) zu einem Grundkörper des Verlagerungsmittels (7) und/oder zu der Trageinrichtung (11) und/oder
- das wenigstens eine Lagerungsmittel (10, 10') innerhalb der Trageinrichtung (11) und/oder
- das Lagerungsmittel (10, 10') um eine lagerungsmittelseitige Rotationsachse (20) und/oder
- eine Sammeleinrichtung (34)
vermittels eines Motors verfahrbar bzw. bewegbar ist.

15. Vorrichtung (1) nach einem der vorhergehenden Ansprüche, **gekennzeichnet durch** eine Sammeleinrichtung (34) die eingerichtet ist, wenigstens eine aus der Prozesskammer (5) herausbewegte Baugruppe (2, 2') aufzunehmen, wobei optional die Sammeleinrichtung (34) eine Temperiereinrichtung, insbesondere eine Kühleinrichtung, umfasst oder eine Temperiereinrichtung, insbesondere einer Kühleinrichtung, der Sammeleinrichtung (34) zugeordnet ist, sodass vermittels der Temperiereinrichtung, insbesondere Kühleinrichtung, wenigstens eine in der Sammeleinrichtung (34) aufgenommene Baugruppe (2, 2') temperierbar, insbesondere zu kühlbar, ist.

## Claims

1. Device (1) for relocating at least one assembly (2, 2") between a provisioning region (3) and a working region (4) at least one process chamber (5) of a process chamber device (6) for reflow soldering, with at least one publisher means (7), wherein the at least one assembly (2, 2") by means of a transmitted or generated by the publisher means (7), acting on the assembly (2, 2") force (8) at least sectionally performs a displacement movement (9) in such a way or such a displacement movement (9) is executable that the at least one assembly (2, 2") is relocated, comprising
a support device (11) comprising at least one bearing means (10, 10"), wherein the at least one assembly (2, 2") is at least intercepted or arranged on the bearing means (10, 10) during the displacement movement (9) and is movable and/or movable on the carrier means (11) by means of the bearing means (10, 10) at least in the direction of the displacement movement (9), **characterized in that**
at least one retention means (15) can be arranged or arranged at an end portion of the support (11) which is movable between a locking position (16) and a release position (17), wherein in the locking position (16) a movement of at least one of the supported by the support (11) assembly (2, 2") in the direction of the displacement movement (9) is inhibited and in the release position (17) a movement of at least one of the supported by the support (11) assembly (2, 2") in the direction of the displacement movement (9) is released.

2. Device (1) according to claim 1, **characterized in that** the at least one assembly (2, 2 ") is at least in sections, preferably predominantly, while the displacement movement (9) on the bearing means (10, 10 ") is directly arranged or arranged and by means of the bearing means (10, 10 ") at least in the direction of the displacement movement (9) movable and / or movable on the carrier means (11) is stored.

3. Device (1) according to claim 1 or 2, **characterized in that** the device (1) is arranged, in a first portion of the displacement movement (9) a displacement of the at least one assembly (2, 2 "), at least by a movement of one of the at least one assembly (2, 2 "), at least sectionally supporting support means (13), in particular a bearing means (10, 10 "), the supporting device (11) and in a further portion of the displacement movement (9) a displacement of the at least one assembly (2, 2 "), at least by the action of the media (7) on the at least one assembly (2, 2 ") acting force (8) is carried out.

4. Device (1) according to one of the preceding claims, **characterized in that** the at least one retaining means (15) comprises a support region (18) for at least temporary support of at least one moving during at least one portion of the displacement movement (9) assembly (2, 2 "), preferably the at least one retaining means (15) is arranged or formed in such a way that the at least one retaining means (15) at least in the release position (17) reduces one of the at least one assembly (2, 2 ") to pass interruption of a contact region of the assembly (2, 2 ") with the support (11) and the process chamber (5, 5 ").

5. Device (1) according to one of the preceding claims, **characterized in that** the device (1) is arranged to move in at least one portion of the displacement movement (9) the at least one assembly (2, 2") by means of a superimposed action of a by the publisher means (7) on the at least one assembly (2, 2 "acting force (8) and a movement of the at least one assembly (2, 2 "bearing support means (13), in particular at least one bearing means (10, 10 "), a support device (11).

6. Device (1) according to one of the preceding claims, **characterized by** at least one bearing means (10, 10 "), in particular aligned perpendicular to the displacement movement (9), rotatably mounted on a bearing means (10, 10 "), wherein preferably at least one component of the displacement movement (9) of the at least one mounted on a bearing means (10, 10 ") assembly (2, 2 ") due to the action of the publishing means (7) on the at least one assembly (2, 2 " under rotational movement (21) of the at least one rotatably mounted bearing means (10, 10 ") around the rotation axis (20) is executable.

7. Device (1) according to one of the preceding claims, **characterized in that** at least two bearing means (10, 10") are connected via a connecting member (22) and are movable at least in sections in the direction of the displacement movement (9), in particular motor-driven, the device (1) is preferably arranged that at least two bearing means (10, 10") carry out a at least in sections linear transport movement in the direction of the displacement movement (9), in which an assembly (2, 2") arranged on these bearing means (10, 10") carries out at least one component of a, in particular linear, displacement movement (9).

8. Device (1) according to one of the preceding claims, **characterized in that** the at least one publishing means (7) comprises at least one movably mounted on a movable holding body (23) displacement element (24) for at least temporary contact with at least one assembly (2, 2 "), wherein the displacement element (24) is at least partially parallel and / or perpendicular to the displacement movement (9) movable, wherein optionally the holding body (23) movable to a base body of the publishing means (7) and / or to the supporting device (11) is fixed or fixed, preferably the holding body (23) is perpendicular and / or parallel movable to a main stretching plane of the holding body (23) and / or to a main stretching plane of the base body and / or to a main stretching plane of the support (11), optionally, the retaining body (23) and / or a movably mounted on the retaining body pull-out body (46) between a first, with the base body and / or with a base body (40) of the supporting device (11) at least predominantly, in particular completely, covered cover position and a second, laterally offset to the base body and / or to the base body (40) of the supporting device (11) positioned pull-out position (27), preferably motor driven, movable or extendable.

9. Device (1) according to one of the preceding claims, **characterized in that** the supporting device (11) comprises wall bodies (28, 28 ") running parallel to the displacement movement (9) and aligned parallel to each other, wherein between two wall bodies (28, 28 ") a receiving track (29, 29 ") for receiving at least one assembly (2, 2 "), in particular a first group of assemblies (2, 2 "), is formed, preferably the distance (30) of the wall body (28, 28 ") corresponds at least approximately to the in transverse direction to the displacement movement (9) present longitudinal dimension of at least one assembly (2, ").

10. Device (1) according to one of the preceding claims, **characterized in that** the supporting device (11) has at least one receiving track (29, 29 ") for the supporting receiving of at least one assembly (2, 2 "), wherein at least one receiving track width of at least one receiving track (29, 29 ") is changeable, in particular by a motor, is changeable; and/or
that the support device (11) is perpendicular to the displacement movement (9) of at least one assembly (2, 2 "), in particular parallel to a main extension plane of the support device (11), movable for the execution of an alignment movement (31), is preferably by means of the alignment movement (31) optionally a first receiving track (29) of the support device (11) for receiving at least one assembly (2, 2 ") and at least a second receiving track (29 ") of the support device (11) for receiving at least one further assembly (2, 2 ") to a, in particular single-track, insertion area (32) for introducing at least one assembly (2, 2 ") to the support device (11) in a corresponding orientation and / or position movable.

11. Device (1) according to one of the preceding claims, **characterized by** a process chamber device (6) having at least two superimposed process chambers (5, 5 "), wherein the support device (11) is so height-shiftable that at least one supported by the support device (11) assembly (2, 2 ") is optionally relocated to a first or another process chamber (5, 5 ") of the process chamber device (6); and/or
by a process chamber device (6) having at least one process chamber (5, 5 "), wherein at least one process chamber (5, 5 ") has a first and a further transfer opening (33, 33 ") for passing through at least one assembly (2, 2 ") between a process chamber-side working area (4) and a load-bearing device-side provisioning area 3 and / or a collecting device-side collection area (35), wherein the transfer openings (33, 33 ") are preferably arranged or formed on two opposite side surfaces of the, in particular cuboid-like, process chamber (5); and/or
by a process chamber device (6) having at least one process chamber (5) and a collection device (34), wherein the collection device (34) comprises a collection carrier (36) which can be moved horizontally and / or vertically to accommodate at least one assembly (2, 2") moved out of the process chamber (5, 5 "), preferably the collection device (34) has several, in particular arranged or formed on top of each other, groups of recording tracks 37, 37 ", 37 "".

12. Device (1) according to one of the preceding claims, **characterized in that** the publishing means (7) is arranged,
- an assembly (2, 2") arranged in a load-bearing device-side provisioning area (3) into a process chamber-side working area (4) and/or
- an assembly (2, 2") arranged in a process chamber-side working area (4) into a load-bearing device-side provisioning area (3) and/or
- an assembly (2, 2") arranged in a process chamber-side working area (4) into a collecting device-side collecting area (35) and/or
- an assembly (2, 2") arranged in a collecting device-side collection area (35) into a process chamber-side working area (4)
to move, in particular, the movement of the assembly (2, 2") is effected by contact and application of a force, preferably a compressive force (8), to move on at least one assembly (2, 2") by a relocating means side shifting element (24) of the publishing means (7).

13. Device (1) according to one of the preceding claims, **characterized in that** the publishing means (7) is arranged such that a movement of an assembly (2, 2")
- at and/or via a gap (19) between the load-bearing device-side provisioning area (3) and the process chamber-side working area (4) and/or
- on one and/or via a gap between the process chamber-side working area (4) and the collecting device-side collecting area (35) and/or
- within the working area (4) and/or
- within the provisioning area (4)
at least in sections, in particular completely, exclusively, by the action of the publishing medium (7).

14. Device (1) according to one of the preceding claims, **characterized in that**
- the publishing medium (7) at least partially to the supporting device (11) and/or
- the displacement element (24) to the holding body (23) and/or
- the holding body (23) to a basic body of the publishing medium (7) and/or to the supporting device (11) and/or
- that at least one bearing means (10, 10") within the supporting device (11)
and/or
- the bearing means (10, 10") around a bearing means rotation axis (20)
and/or
- a collection facility (34)
is movable or movable by means of an engine.

15. Device (1) according to one of the preceding claims, **characterized by** a collection device (34) which is equipped to accommodate at least one assembly (2, 2") moved out of the process chamber (5), wherein optionally the collection device (34) comprises a temperature control device, in particular a cooling device, or a temperature control device, in particular a cooling device, is assigned to the collection device (34), so that by means of the temperature control device, in particular cooling device, at least one assembly (2, 2") absorbed in the collection device (34) can be temperature controlled, in particular to be cooled.

## Revendications

1. Dispositif (1) pour le déplacement d'au moins un assemblage (2, 2') entre une zone de mise à disposition (3) et une zone de travail (4) d'au moins une chambre de procédé (5) d'un dispositif de chambre de procédé (6) pour le brasage à refusion, avec au moins un agent de déplacement (7), dans lequel au moins un assemblage (2, 2') est réalisé au moyen d'une force transmise ou produite par l'agent de déplacement (7) agissant sur l'assemblage (2, 2') (8) effectuant au moins par sections un mouvement de déplacement (9) ou un tel mouvement de déplacement (9) pouvant être réalisé de manière à transférer au moins un assemblage (2, 2'), comprenant:
une structure portante (11) comprenant au moins un moyen de stockage (10, 10'), dans laquelle au moins un ensemble (2, 2') peut être disposé ou disposé au moins par sections sur le moyen de stockage (10, 10') pendant le mouvement de déplacement (9) et est stocké au moyen du moyen de stockage (10, 10') au moins dans le sens du mouvement de déplacement (9) de manière mobile et/ou mobile sur le support (11), **caractérisée en ce que**: au moins un dispositif de retenue (15) pouvant se déplacer entre une position de blocage (16) et une position de dégagement (17) peut être installé ou placé à une extrémité de la structure porteuse (11), en inhibant, dans la position de blocage (16), un mouvement d'au moins un ensemble (2, 2') porté par la structure porteuse (11) vers le mouvement de déplacement (9) et en libérant, dans la position de dégagement (17), un mouvement d'au moins un ensemble (2, 2') porté par la structure porteuse (11) vers le mouvement de déplacement (9).

2. Dispositif (1) selon la revendication 1, **caractérisé en ce qu'**au moins un assemblage (2, 2') est, au moins par sections, de préférence de manière prépondérante, directement arrangable ou disposé sur le moyen de stockage (10, 10') pendant le mouvement de déplacement (9) et, au moyen du moyen de stockage (10, 10'), au moins dans le sens du mouvement de déplacement (9), mobile et/ou mobile sur le support (11).

3. Dispositif (1) selon la revendication 1 ou 2, **caractérisé en ce que** le dispositif (1) est installé, dans une première section du mouvement de déplacement (9), un déplacement d'au moins un assemblage (2, 2') est effectué au moins par un mouvement d'un support portant au moins un assemblage (2, 2') au moins par section (13), en particulier d'un moyen de stockage (10, 10'), de l'appareil de support (11) et, dans une autre section du mouvement de déplacement (9), un déplacement d'au moins un assemblage (2, 2') au moins par l'action de la force agissant au moyen du moyen du moyen de déplacement (7) sur au moins un assemblage (2, 2') (8).

4. Dispositif (1) selon l'une quelconque des revendications précédentes, **caractérisé en ce qu'**il comprend au moins un moyen de retenue (15) une zone d'appui (18) pour soutenir au moins temporairement au moins un ensemble (2, 2') en mouvement pendant au moins une partie du mouvement de déplacement (9), il est préférable qu'au moins un moyen de retenue (15) soit disposé ou formé de telle sorte que le moyen de retenue (15) au moins en position de libération (17) réduise une interruption d'une zone de contact de l'ensemble (2, 2') avec le dispositif porteur (11) et la chambre de procédé (5, 5') qui doit passer par au moins un ensemble (2, 2').

5. Dispositif (1) selon l'une quelconque des revendications précédentes, **caractérisé en ce que** le dispositif (1) est installé pour déplacer, dans au moins une section du mouvement de déplacement (9), au moins un assemblage (2, 2') au moyen d'une action superposée d'une force exercée par l'agent de déplacement (7) sur au moins un assemblage (2, 2') (8) et d'un mouvement de la structure portante portant au moins un assemblage (2, 2') (13), en particulier au moins un moyen de stockage (10, 10'), une structure portante (11).

6. Dispositif (1) selon l'une quelconque des revendications précédentes, **caractérisé par** au moins un élément du mouvement de déplacement (9) d'au moins un assemblage (2, 2') disposé sur un assemblage (10, 10') en raison de l'action de l'agent de déplacement (7) sur au moins un assemblage (2, 2') exécutable sous mouvement de rotation (21) d'au moins un assemblage (10, 10') monté sur un assemblage (10, 10') en raison de l'action de l'agent de déplacement (7) sur au moins un assemblage (2, 2') exécutable sous mouvement de rotation (21) autour de l'axe de rotation (20).

7. Dispositif (1) selon l'une quelconque des revendications précédentes, **caractérisé en ce qu'**au moins deux moyens de stockage (10, 10') sont reliés par un lien (22) et sont mobiles, en particulier motrices, au moins par section dans le sens du mouvement de déplacement (9), le dispositif (1) est de préférence aménagé pour qu'au moins deux moyens de stockage (10, 10') effectuent un mouvement de transport linéaire au moins par section dans le sens du mouvement de déplacement (9), dans lequel un assemblage (2, 2') placé sur ces moyens de stockage (10, 10') exécute au moins un composant d'un mouvement de déplacement (9), en particulier linéaire.

8. Dispositif (1) selon l'une quelconque des revendications précédentes, **caractérisé en ce qu'**il comprend au moins un moyen de déplacement (7) comprenant au moins un élément de déplacement (24) articulé sur un élément de retenue du côté du moyen de déplacement (23) au contact au moins temporaire d'au moins un ensemble (2, 2'), l'élément de déplacement (24) étant articulé au moins par sections parallèles et/ou perpendiculaires au mouvement de déplacement (9), le corps de retenue (23) étant articulé ou fixé, en option, à un élément de base du moyen de déplacement (7) et/ou à la structure porteuse (11), de préférence le corps de retenue (23) perpendiculairement et/ou parallèlement à un plan d'extension principal du corps de retenue (23) et/ou à un plan d'extension principal du corps de base et/ou à un plan d'extension principal de la structure porteuse (11), en option, le corps de retenue (23) et/ou un corps d'extension (46) monté de manière mobile sur le corps de retenue entre une première position d'extension (27) positionnée avec le corps de base et/ou avec un corps de base (40) de la structure porteuse (11) au moins principalement, en particulier complètement, en position de couverture et une seconde position d'extension (27) positionnée latéralement par rapport au corps de base et/ou au corps de base (40) de la structure porteuse (11), de préférence motrice, mobile ou extensible.

9. Dispositif (1) selon l'une quelconque des revendications précédentes, **caractérisé en ce que** l'élément porteur (11) comprend des corps de paroi (28, 28') parallèles au mouvement de déplacement (9) et alignés les uns par rapport aux autres, dans lequel une voie de réception (29, 29') est formée entre deux corps de paroi (28, 28') pour recevoir au moins un assemblage (2, 2'), en particulier un premier groupe d'assemblages (2, 2'), la distance (30) des corps de paroi (28, 28') correspond de préférence au moins approximativement à la longueur d'au moins un assemblage (2, 2') présente dans le sens transversal au mouvement de déplacement (9).

10. Dispositif (1) selon l'une quelconque des revendications précédentes, **caractérisé en ce que** l'appareil porteur (11) comporte au moins une voie de réception (29, 29') pour la réception portante d'au moins un ensemble (2, 2'), étant entendu qu'au moins une largeur de voie de réception d'au moins une voie de réception (29, 29') est modifiable, notamment par un moteur; et/ou que l'installation porteuse (11) peut être déplacée perpendiculairement au mouvement de déplacement (9) d'au moins un ensemble (2, 2'), en particulier parallèlement à un plan d'extension principal de l'installation porteuse (11), pour effectuer un mouvement d'alignement (31), la préférence est donnée, au moyen du mouvement d'alignement (31), à une première voie de réception (29) de l'installation porteuse (11) pour recevoir au moins un ensemble (2, 2') et au moins une deuxième voie de réception (29') de l'installation porteuse (11) pour recevoir au moins un autre ensemble (2, 2') vers une zone d'insertion (32) à une voie, en particulier à une seule voie, pour introduire au moins un ensemble (2, 2') à l'installation porteuse (11) dans une orientation et/ou une position correspondantes.

11. Dispositif (1) selon l'une quelconque des revendications précédentes, **caractérisé par** un dispositif de chambre de procédé (6) comportant au moins deux chambres de procédé superposées (5, 5'), dans lequel le dispositif de support (11) peut être déplacé en hauteur de telle sorte qu'au moins un assemblage (2, 2') porté par le dispositif de support (11) peut être déplacé, au choix, dans une première chambre de procédé ou dans une autre chambre de procédé (5, 5') du dispositif de chambre de procédé (6); et/ou
par un dispositif de chambre de procédé (6) comprenant au moins une chambre de procédé (5, 5'), dans lequel au moins une chambre de procédé (5, 5') comporte une première ouverture de transfert et une autre ouverture de transfert (33, 33') permettant d'effectuer au moins un assemblage (2, 2') entre une zone de travail côté chambre de procédé (4) et une zone de mise à disposition côté dispositif porteur 3 et/ou une zone de collecte côté dispositif collecteur (35), les ouvertures de transfert (33, 33') étant disposées ou formées de préférence sur deux faces latérales opposées de la chambre de procédé (5), notamment parallélépipédique; et/ou
par un dispositif de chambre de procédé (6) comprenant au moins une chambre de procédé (5) et un dispositif de collecte (34), dans lequel le dispositif de collecte (34) comprend un support de collecte (36) qui peut être déplacé horizontalement et/ou verticalement pour accueillir au moins un assemblage (2, 2') qui sort de la chambre de procédé (5, 5'), l'installation de collecte (34) présente de préférence plusieurs groupes de pistes de réception 37, 37', 37', 37", formés notamment les uns au-dessus des autres.

12. Dispositif (1) selon l'une quelconque des revendications précédentes, **caractérisé en ce que** le moyen de déplacement (7) est installé,
- un ensemble (2, 2') disposé dans une zone de mise à disposition côté structure porteuse (3) dans une zone de travail côté chambre de procédé (4) et/ou
- un ensemble (2, 2') disposé dans une zone de travail côté chambre de procédé (4) dans une zone de mise à disposition côté structure porteuse (3) et/ou
- un ensemble (2, 2') disposé dans une zone de travail côté chambre de procédé (4) dans une zone de collecte côté dispositif de collecte (35) et/ou
- un ensemble (2, 2') placé dans une zone de rassemblement côté dispositif collecteur (35) dans une zone de travail côté chambre de procédé (4)
en particulier, le mouvement de l'ensemble (2, 2') se fait par contact et application d'une force, de préférence une force de compression (8), sur au moins un ensemble (2, 2') par un élément de déplacement côté déplacement (24) de l'élément de déplacement (7).

13. Dispositif (1) selon l'une quelconque des revendications précédentes, **caractérisé en ce que** le moyen de déplacement (7) est aménagé de telle sorte qu'un mouvement d'un assemblage (2, 2')
- sur et/ou au-dessus d'un espace (19) entre la zone de mise à disposition côté structure porteuse (3) et la zone de travail côté chambre de procédé (4) et/ou
- sur et/ou au-dessus d'un espace entre la zone de travail côté chambre de procédé (4) et la zone de collecte côté dispositif de collecte (35) et/ou
- dans la zone de travail (4) et/ou
- dans la zone de mise à disposition (4)
au moins partiellement, en particulier intégralement, exclusivement, par l'action du moyen de transfert (7).

14. Dispositif (1) selon l'une quelconque des revendications précédentes, **caractérisé en ce que**:
- le moyen de déplacement (7) au moins en partie vers la structure porteuse (11) et/ou
- l'élément de déplacement (24) vers le corps de retenue (23) et/ou
- le corps de retenue (23) à un corps de base de l'agent de déplacement (7) et/ou à la structure porteuse (11) et/ou
- au moins un moyen de stockage (10, 10') à l'intérieur de la structure porteuse (11) et/ou
- l'agent de stockage (10, 10') autour d'un axe de rotation du centre de stockage (20) et/ou
- une installation de collecte (34)
est déplaçable ou déplaçable au moyen d'un moteur.

15. Dispositif (1) selon l'une quelconque des revendications précédentes, **caractérisé par** un dispositif de collecte (34) équipé pour accueillir au moins un assemblage (2, 2') déplacé hors de la chambre de procédé (5), dans lequel, en option, le dispositif de collecte (34) comprend un dispositif de thermorégulation, en particulier un dispositif de réfrigération, ou un dispositif de thermorégulation, en particulier un dispositif de réfrigération, est rattaché au dispositif de collecte (34), de sorte que, par l'intermédiaire du dispositif de thermorégulation, en particulier un dispositif de réfrigération, au moins un assemblage (2, 2') inséré dans le dispositif de collecte (34) est thermorégulable, en particulier à refroidir.
